(19) Europäisches Patentamt / European Patent Office / Office européen des brevets

(11) **EP 4 369 884 B1**

(12) **FASCICULE DE BREVET EUROPÉEN**

(45) Date de publication et mention
de la délivrance du brevet:
**25.06.2025 Bulletin 2025/26**

(21) Numéro de dépôt: **23208380.8**

(22) Date de dépôt: **07.11.2023**

(51) Classification Internationale des Brevets (IPC):
**H10B 63/00** *(2023.01)*

(52) Classification Coopérative des Brevets (CPC):
**H10B 63/845**

(54) **STRUCTURE TRIDIMENSIONNELLE DE MÉMOIRES DE TYPE NOR**

DREIDIMENSIONALE STRUKTUR VON NOR-SPEICHERN

THREE-DIMENSIONAL STRUCTURE OF NOR-TYPE MEMORIES

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **09.11.2022 FR 2211695**

(43) Date de publication de la demande:
**15.05.2024 Bulletin 2024/20**

(73) Titulaires:
• **Commissariat à l'Energie Atomique et aux Energies Alternatives**
**75015 Paris (FR)**
• **Centre National de la Recherche Scientifique**
**75794 Paris Cedex 16 (FR)**
• **Université d'Aix Marseille**
**13284 Marseille Cedex 07 (FR)**

(72) Inventeurs:
• **EZZADEEN, Mona**
**38054 GRENOBLE CEDEX 09 (FR)**
• **ANDRIEU, François**
**38054 GRENOBLE CEDEX 09 (FR)**
• **PORTAL, Jean-Michel**
**13119 SAINT SAVOURNIN (FR)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
**US-A1- 2019 006 386     US-A1- 2020 411 097
US-A1- 2022 157 845     US-B1- 9 711 229**

**Description**

**Champ d'application**

La présente invention concerne le domaine de l'intégration des circuits de stockage de données basés sur des structures mémoires tridimensionnelles. Plus particulièrement, l'invention concerne une configuration de connexion optimale d'une structure mémoire tridimensionnelle à base de mémoires non-volatiles résistives avec sa circuiterie périphérique réalisée sur un substrat semiconducteur différent.

**Problème technique**

Les technologies émergentes des mémoires non-volatiles permettent de réaliser des circuits de mémoire plus denses et plus compacts par rapport aux structures planaires classiques. Cependant, les solutions actuelles de circuits de stockage tridimensionnels présentent une contrainte majeure qui consiste en la difficulté d'accéder individuellement à chaque cellule mémoire de la structure pour réaliser des opérations de lecture et/ou d'écriture. Cette contrainte de connectivité induit la nécessité d'un fonctionnement séquentiel. Ce type de fonctionnement augmente le temps nécessaire pour les opérations de lecture et/ou d'écriture et réduit ainsi la performance du circuit de stockage.

L'architecture de type « NOR » présente un candidat prometteur pour augmenter le parallélisme d'accès et ainsi augmenter la performance des circuits de stockage 3D. En effet, dans une architecture mémoire de type « NOR », toutes les cellules mémoires sont accessibles en lecture et en écriture d'une manière indépendante et individuelle sans qu'il soit nécessaire de présélectionner ou inhiber les cellules mémoires adjacentes. Cela offre une flexibilité de programmation et un gain considérable en temps d'exécution. Cependant, l'implémentation d'une architecture de type NOR dans une structure mémoire tridimensionnelle sur un seul substrat présente au moins les contraintes techniques suivantes :

- Le recours à de larges circuits périphériques aux mémoires. Ces circuits périphériques couvrent à titre d'exemple une pluralité d'amplificateurs de détection et des circuits de commande de lecture et d'écriture. Cela augmente considérablement la surface du circuit et la complexité d'implémentation physique ;
- La nécessité d'utiliser plusieurs niveaux de pistes métalliques pour réaliser les interconnexions complexes entre les cellules mémoires et les circuits périphériques. Cette contrainte est d'autant plus importante avec l'augmentation de la taille de la structure mémoire tridimensionnelle ; et
- La faible performance des cellules mémoire utilisées dans les structures mémoire tridimensionnelles par rapport aux transistors selon des nœuds technologiques avancées.

Ainsi, il existe un besoin pour concevoir des nouvelles architectures de circuits de stockage 3D, qui soient moins complexes, plus denses et présentant en même temps une flexibilité d'accès en lecture/écriture et une amélioration des performances en termes de vitesse d'exécution.

**Art antérieur/ Restrictions de l'état de l'art**

Les solutions connus de type Flash NOR en deux dimensions (planaire) présentent une structure avec la possibilité de parallélisation des opérations d'écriture et de lecture. L'inconvénient de ce type de structure est que la parallélisation se fait aux dépens de sa densité spatiale de la structure. Cela présente une limitation du nombre de de cellules mémoire sur une surface prédéterminée.

Les solutions connus de type NAND en trois dimensions (cubique) présentent une structure avec une densité spatiale améliorée. L'inconvénient de ce type de structure est que la parallélisation des opérations de lecture/écriture est très limité. L'accès séquentiel est imposé par un accès électrique aux nœuds d'entrée/sortie partagé entre les cellules mémoire montés en série dans ce type de structure.

Un exemple de l'art antérieur se trouve dans le document US2022/0157845 A1. Le document divulgue un structure tridimensionnelle de mémoire de type NOR.

**Réponse au problème et apport solution**

Pour pallier les limitations des solutions existantes d'un point de vue densité et parallélisme d'opérations, l'invention propose un circuit basé sur une structure mémoire tridimensionnelle réalisée sur un premier substrat semiconducteur et connectée verticalement à des circuits périphériques réalisés sur un second substrat semiconducteur. Le second substrat semiconducteur est superposé à la structure mémoire tridimensionnelle. La connexion entre les circuits périphériques et les cellules mémoires de la structure mémoire 3D se fait à travers des connexions verticales (sous forme de vias) et une distribution de plots de connexion confinés entre la structure 3D et le second substrat semiconducteur.

Le dispositif selon l'invention présente une distribution optimale des plots de connexion permettant de diviser la structure mémoire 3D en plusieurs sous-matrices de cellules mémoires indépendants. Cela permet d'obtenir une structure de type « NOR » et d'améliorer le parallélisme des opérations de lecture et d'écriture de cellules mémoires. L'invention permet ainsi la réalisation d'un découpage innovant par bloc et d'un routage pour avoir un accès de type NOR. Cela permet d'obtenir une granularité fine dans la structure tridimensionnelle, offrant la possibilité d'une forte parallélisation en lecture et en écriture.

De plus, le dispositif selon l'invention est réalisable avec un nombre de cellules mémoires considérablement supérieur à celui des solutions connues en mémoire non volatile de type NOR (flash NOR 2D par exemple). Cela offre l'avantage de la multiplication des capacités de stockage. Ainsi, le dispositif est capable de paralléliser un nombre considérable d'opérations de traitement de données pour obtenir une performance meilleure.

Le dispositif selon l'invention permet en outre de réduire la complexité des circuits périphériques en utilisant des transistors à nœuds technologiques avancés occupant moins de surface et ayant une performance améliorée. A titre d'exemple, les transistors à nœuds technologiques avancés couvrent des transistors ayant un nœud technologique inférieur à 28nm.

**Résumé / Revendications**

L'invention a pour objet un circuit de stockage de données, de type NOR comprenant :

- une structure mémoire tridimensionnelle , réalisée sur un premier substrat semiconducteur , et comprenant une pluralité de plans mémoire de rang i allant de 1 à N, avec N un entier naturel supérieur à 1, chaque plan formant une matrice bidimensionnelle de cellules mémoire non volatiles, résistives et programmables. Chaque cellule mémoire a un nœud de sélection, un premier nœud d'entrée/sortie et un second nœud d'entrée/sortie. Ladite matrice comprend M lignes de rang j allant de 1 à M et K colonnes de rang k allant de 1 à K, avec M et K deux entiers naturels non nuls.

Pour chaque plan mémoire : les premiers nœuds d'entrée/sorties des cellules mémoires appartenant à la même colonne sont interconnectés; et les seconds nœuds d'entrée/sorties des cellules mémoires appartenant à la même colonne sont interconnectés. La structure mémoire tridimensionnelle a une surface supérieure comprenant une pluralité de connecteurs répartis sur ladite surface ; chaque connecteur étant connecté à au moins l'un parmi les premiers ou les seconds nœuds d'entrée/sortie d'une même colonne ;

- un circuit de contrôle configuré pour appliquer des tensions de commande sur les nœuds de chaque cellule mémoire ; et réalisé sur un second substrat semiconducteur ; le circuit de contrôle étant superposé à ladite surface supérieure ;

- une structure d'interconnexion comprenant :

  • une pluralité de plots de connexions disposés entre le circuit de contrôle et ladite surface supérieure ; chaque plot de connexion connectant le circuit de contrôle à un connecteur dédié ; chaque plot de connexion étant connecté à un groupe élémentaire de cellules mémoires appartenant à des plans mémoires distincts. Ladite pluralité de plots de connexion forme une répétition périodique d'un motif unitaire dans un plan parallèle à la surface supérieure.

Selon un aspect particulier de l'invention, chaque plot de connexion présente une première dimension selon une première direction et une seconde dimension selon une seconde direction. La largeur selon la première direction du motif unitaire selon la première direction étant égale à ladite première dimension multipliée par $4* nb_x$, avec $nb_x$ le nombre de connecteurs couverts par l'aire plot de connexion appartenant à un même plan mémoire selon la seconde direction. La longueur étant égale à deux fois la seconde dimension dudit plot de connexion selon la seconde direction.

Selon un aspect particulier de l'invention, la structure d'interconnexion comprend en outre pour chaque groupe élémentaire :

- une première piste de connexion pour interconnecter les premiers nœuds d'entrée/sortie des cellules mémoires appartenants à des colonnes de même rang k d'une pluralité de plans mémoire distincts ;

- une seconde piste de connexion pour interconnecter les seconds nœuds d'entrée/sortie des cellules mémoires appartenants à des colonnes de même rang k d'une pluralité de plans mémoire distincts.

Selon un aspect particulier de l'invention, le circuit de stockage de données comprend en outre une couche de diélectrique encapsulant la structure mémoire tridimensionnelle et supportant la pluralité de plots de connexions.

Selon un aspect particulier de l'invention, la structure d'interconnexion comprend en outre un ensemble de vias traversant la couche de diélectrique. Chaque via parmi l'ensemble de vias étant destiné à connecter un plot de connexions à un connecteur associé.

Selon un aspect particulier de l'invention, le circuit de stockage de données comprend en outre au moins un circuit de lecture réalisé sur le second substrat semiconducteur.

Selon un aspect particulier de l'invention, chaque circuit de lecture comprend un inverseur apte à réaliser une lecture différentielle de deux cellules mémoires appartenant à deux colonnes adjacentes et ayant un premier nœud d'entrée/sortie commun et ayant deux seconds nœuds d'entrée/sortie destinés à recevoir des signaux de commande complémentaires.

Selon un aspect particulier de l'invention, chaque cellule mémoire comprend :

- une structure de stockage résistive programmable ayant :

  • une électrode supérieure connectée au second nœud d'entrée/sortie de ladite cellule mémoire ;

  • et une électrode inférieure ;

- un transistor de sélection ayant une grille connectée au nœud de sélection de ladite cellule mémoire et reliant l'électrode inférieure au premier nœud d'entrée/sortie de ladite cellule mémoire.

Selon un aspect particulier de l'invention, chaque colonne de cellules mémoire comprend :

- Un empilement d'une pluralité de transistors de sélection selon une première direction ;

  chaque transistor de sélection étant de type grille enrobante et comprenant un canal de conduction, perpendiculaire à la première direction en un matériau semiconducteur et ayant deux extrémités ;
  la première extrémité du canal correspondant à la source du transistor de sélection et la seconde correspondant au drain du transistor ;

- un premier pilier métallique selon la première direction connectant les sources des différents transistors de sélection ;

- une seconde couche en diélectrique parallèle à la première direction et couvrant latéralement les drains des transistors de sélection ;

- au moins une couche métallique parallèle à la première direction et déposée sur la couche en diélectrique ;

- un second pilier métallique selon la première direction ayant un contact latéral avec l'au moins une couche métallique ;

pour chaque transistor de sélection, l'ensemble formé par la source, la couche en diélectrique et la couche métallique constitue une structure de stockage élémentaire résistive.

Selon un aspect particulier de l'invention, l'aire d'un plot de connexion est égale à l'aire d'une zone de la surface supérieure comprenant un seul connecteur. Le motif unitaire comprend trois plots de connexions. Le motif unitaire couvre un groupe élémentaire de cellules mémoires appartenant à six plans mémoires distincts successifs.

Selon un aspect particulier de l'invention, l'aire d'un plot de connexion est égale à l'aire d'une zone de la surface supérieure comprenant au moins six connecteurs. Le motif unitaire comprend au moins six plots de connexions. Le motif unitaire couvre un groupe élémentaire de cellules mémoires appartenant à au moins 96 plans mémoires distincts successifs.

Selon un aspect particulier de l'invention, le motif unitaire comprend un premier sous-groupe de plots de connexion et un deuxième sous-groupe de plots de connexion, les sous-groupes étant symétriques l'un par rapport à l'autre selon un point central du motif unitaire.

Selon un aspect particulier de l'invention, le motif unitaire recouvre deux groupes d'un nombre égal de colonne(s), chaque groupe de colonne(s) étant connecté à un même nombre de plots de connexion.

## Description détaillée

D'autres caractéristiques et avantages de la présente invention apparaîtront mieux à la lecture de la description qui suit en relation aux dessins annexés suivants.

[Fig. 1a] la figure 1a illustre une vue en coupe d'une structure élémentaire de stockage résistive programmable.

[Fig. 1b] la figure 1b illustre une cellule mémoire utilisée pour réaliser le circuit de stockage selon l'invention.

[Fig. 2] la figure 2 illustre un schéma électrique de la structure mémoire tridimensionnelle utilisée dans le circuit de stockage selon l'invention.

[Fig. 3a] la figure 3a illustre une vue en coupe de la structure en couches minces d'une colonne de cellules mémoires du circuit de stockage selon l'invention.

[Fig. 3b] la figure 3b illustre une vue en coupe de la structure en couches minces de deux colonnes adjacentes de cellules mémoires du circuit de stockage selon l'invention.

[Fig. 3c] la figure 3c illustre une vue en coupe de la structure en couches minces des piliers de connexion des signaux de sélection du circuit de stockage selon l'invention.

[Fig. 3d] la figure 3d illustre une vue en perspective de la structure mémoire tridimensionnelle utilisée dans le circuit de stockage selon l'invention.

[Fig. 4a] la figure 4a illustre une vue en perspective du circuit de stockage selon l'invention.

[Fig. 4b] la figure 4b illustre une vue en coupe du circuit de stockage selon un premier mode de réalisation de l'invention.

[Fig. 4c] la figure 4c illustre une vue en coupe du circuit de stockage selon un second mode de réalisation de l'invention.

[Fig. 5a] la figure 5a illustre une vue de dessus de la surface supérieure de la structure mémoire tridimensionnelle utilisée dans le circuit de stockage selon l'invention.

[Fig. 5b] la figure 5b illustre une vue de dessus de la structure mémoire tridimensionnelle illustrant une première distribution des plots de connexion selon l'invention.

[Fig. 5c] la figure 5c illustre une vue de dessus partielle de la structure mémoire tridimensionnelle illustrant une seconde distribution des plots de connexion selon l'invention.

[Fig. 5d] la figure 5d illustre une vue de dessus partielle de la structure mémoire tridimensionnelle illustrant le dimensionnement d'un motif unitaire de la distribution des plots de connexion selon l'invention.

[Fig. 5e] la figure 5e illustre une vue de dessus globale de la structure mémoire tridimensionnelle illustrant la seconde distribution des plots de connexion selon l'invention.

[Fig. 6a] La figure 6a illustre un premier exemple d'un circuit de lecture compatible avec l'invention.

[Fig. 6b] La figure 6b illustre un second exemple d'un circuit de lecture compatible avec l'invention.

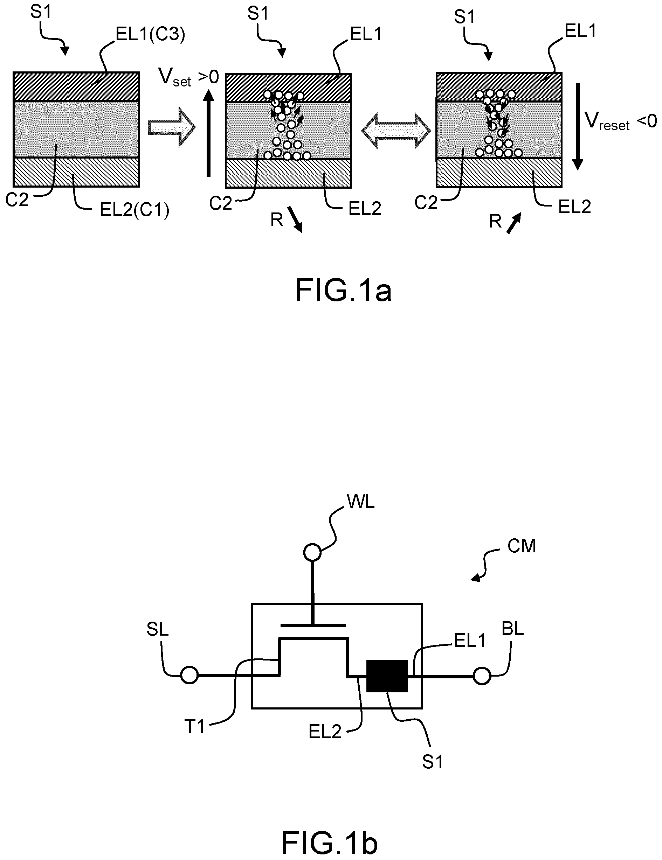

Nous allons commencer par décrire le principe de fonctionnement d'une structure élémentaire de stockage résistive programmable. La figure 1a illustre une vue en coupe d'une structure élémentaire de stockage résistive programmable. La structure élémentaire de stockage S1 se compose de l'empilement de couches minces selon l'ordre suivant : au moins une première couche C1 en un matériau électriquement conducteur formant une électrode inférieure EL2 ; une deuxième couche C2 en un matériau diélectrique et au moins une troisième couche C3 en matériau électriquement conducteur formant une électrode supérieure EL1. Les caractéristiques des matériaux constituant les couches de structure élémentaire mémoire S1 permettent d'obtenir un fonctionnement en mémoire résistive à filament conducteur variable. On dénomme la deuxième couche C2 dans la suite de la description la « couche centrale ».

Alternativement, il est possible de réaliser chaque électrode EL1 et/ou EL2 par un empilement de plusieurs couches conductrices.

À titre d'exemple et sans perte de généralité, la première couche C1 (et donc l'électrode inférieure EL2) et la troisième couche C3 (et donc l'électrode supérieure EL1) sont réalisées en nitrure de titane TiN. L'épaisseur de chacune des couches C1(EL2) et C3 (EL1) est de l'ordre de quelques dizaines de nanomètres, plus particulièrement égale à 100nm.

À titre d'exemple et sans perte de généralité, la couche centrale C2 est réalisée en oxyde d'hafnium. L'épaisseur de la couche centrale C2 est de l'ordre de quelques nanomètres, plus particulièrement égale à 10nm.

Le fonctionnement d'une structure élémentaire de stockage S1 résistive nécessite la formation d'un filament conducteur à travers au moins une partie de la couche centrale C2, isolante électriquement.

Initialement, le structure élémentaire de stockage S1 est une structure de type MIM (métal, isolant, métal) présentant une résistance infinie entre les deux électrodes EL1 et EL2. D'abord, il faut former le filament F à travers au moins une partie du volume de la couche centrale C2. La formation du filament permet d'obtenir une résistance variable en modulant la longueur l du filament conducteur formé. Pour former le filament, on applique une tension électrique positive de formation sur l'électrode supérieure EL1. La tension électrique de formation présente une amplitude et/ou une durée suffisamment élevée afin d'entrainer la génération de lacunes d'oxygène dans la couche centrale C2. En effet, la tension électrique de formation appliquée doit dépasser une valeur prédéterminée de manière à arracher des ions oxygène du réseau cristallin de la couche centrale en oxyde métallique. Les ions vont merger vers l'électrode supérieure EL2 pour former un filament conducteur F à travers la couche centrale constitué des lacunes d'oxygène.

Une fois le filament conducteur F formé, on obtient le comportement d'élément résistif à une résistance variable R selon la longueur du filament conducteur F. Lorsque le potentiel électrique de l'électrode supérieure $V_{EL1}$ est inférieur à celui de l'électrode inférieure $V_{EL2}$, la structure élémentaire de stockage S1 voit une tension $V_{reset}$ négative à ses bornes. Dans ce cas, des ions oxygène vont venir combler une partie des lacunes d'oxygène formant le filament conducteur. Il en résulte une réduction de la longueur du filament conducteur. Ainsi, la résistance de l'élément résistif augmente. On parle d'un état résistif haut et d'une opération d'écriture de type RESET. Inversement, lorsque le potentiel électrique de l'électrode supérieure $V_{EL1}$ est supérieur à celui de l'électrode inférieure $V_{EL2}$, la structure élémentaire de stockage S1 voit une tension $V_{set}$ positive à ses bornes. La longueur du filament conducteur F s'accroît par le même mécanisme décrit pour l'opération de formation du fil. Ainsi, la résistance de l'élément résistif diminue. On parle d'un état résistif bas et d'une opération d'écriture de type SET.

La tension appliquée $V_{set}$ doit être supérieure en valeur absolue à un premier seuil de tension pour passer d'un état résistif haut à un état résistif bas. De même, la tension appliquée $V_{reset}$ doit être supérieure en valeur absolue à un second seuil de tension pour passer d'un état résistif bas à un état résistif haut.

On choisit la convention suivante à titre d'exemple : lorsque la structure élémentaire de stockage S1 est configurée pour stocker une donnée binaire à l'état logique haut (x= 1) elle est à un état résistif bas. Inversement, lorsque la structure élémentaire de stockage S1 est configurée pour stocker une donnée binaire à l'état logique bas (x= 0) elle est à un état résistif haut. Une convention inverse est aussi possible.

La figure 1b illustre un schéma électrique d'une cellule mémoire CM selon l'invention. La cellule mémoire CM comprend une structure mémoire S1 et un transistor de sélection T1. La cellule mémoire CM comprend en outre un nœud de sélection WL, un premier nœud d'entrée/sortie SL et un second nœud d'entrée/sortie BL. L'électrode supérieure EL1 de la structure de stockage S1 est connectée au second nœud d'entrée/sortie BL de la cellule mémoire CM. Le nœud de sélection WL est destiné à recevoir un signal de sélection VWL. La grille du transistor de sélection T1 est connectée au nœud de sélection WL. Le transistor de sélection T1 est monté de manière à relier l'électrode inférieure EL2 au premier nœud d'entrée/sortie SL. Ainsi, la cellule mémoire CM ne peut être écrite en SET ou en RESET que lorsque le transistor T1 est à l'état passant. De plus, le transistor T1 permet de limiter le courant passant à travers la structure de stockage S1 lors d'une opération de SET. La limitation de courant protège la structure S1 du risque de destruction structurelle interne due à la présence de courants forts potentiels lors de la transition d'un état résistif haut à un état résistif bas.

Généralement, il est possible de réaliser dans le cadre de l'invention des cellules mémoires de types OxRAM, CbRAM ou toute autre technologie de mémoire résistive non-volatile.

D'une manière générale, l'invention concerne un circuit de stockage de donnée 1 de type NOR comprenant une structure mémoire tridimensionnelle 10, un circuit de contrôle 20 et une structure d'interconnexion 30. La structure mémoire tridimensionnelle 10 est destinée à stocker des données dans les cellules mémoires CM qui la composent. Le circuit de contrôle 20 est configuré pour appliquer des tensions de commande VBL, VSL et VWL sur les nœuds de chaque cellule mémoire. La structure d'interconnexion 3 est destinée à connecter le circuit de contrôle 20 à la structure mémoire tridimensionnelle 10 de manière à propager les signaux de contrôle associés à chacune des cellules mémoire CM.

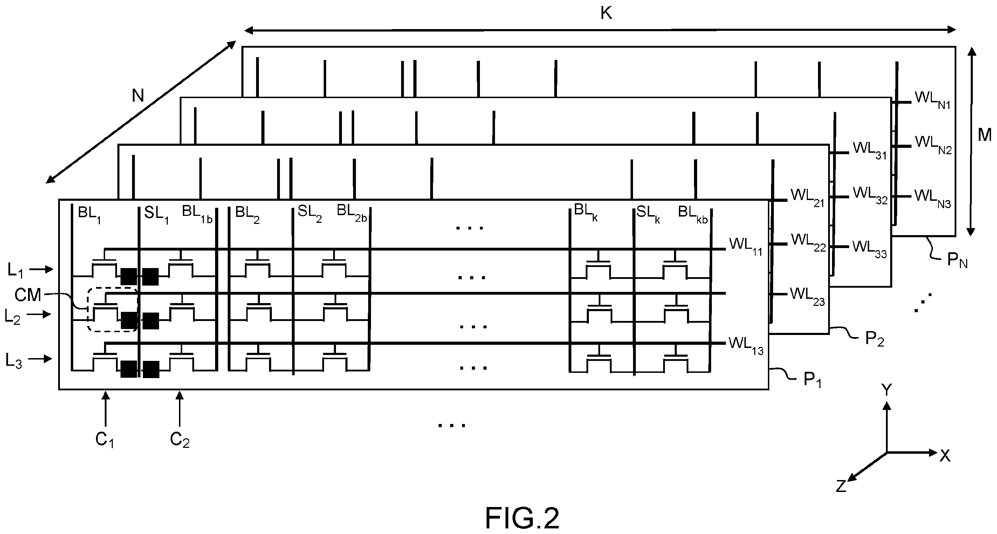

Afin d'exposer clairement l'invention, nous allons commencer par décrire la structure mémoire tridimensionnelle 10. La figure 2 illustre un schéma électrique de la structure mémoire tridimensionnelle utilisée dans le circuit de stockage selon l'invention.

La structure mémoire tridimensionnelle 10 comprend une pluralité de plans mémoire successifs $P_i$ de rangs i de 1 à N, avec N un entier naturel supérieur à 1. Les plans mémoire $P_i$ s'étendent parallèlement au plan géométrique (X,Y) dans un référentiel orthonormé (X,Y,Z). Chaque plan mémoire forme une matrice bidimensionnelle de cellules mémoire CM. Chaque matrice comprend M lignes $L_j$ et K colonnes $C_k$. A titre d'exemple illustratif, le nombre de lignes par matrice est égal à 3.

Dans chaque plan mémoire $P_i$, les nœuds de sélection WL des cellules mémoires appartenant à la même ligne $L_j$ sont interconnectés par une ligne de sélection $WL_{ij}$ commune. Dans chaque plan mémoire $P_i$, les premiers nœuds d'entrée/sorties SL des cellules mémoires appartenant à la même colonne $C_k$ sont interconnectés par une ligne de source commune notée $SL_k$. Dans chaque plan mémoire $P_i$, les seconds nœuds d'entrée/sorties BL des cellules mémoires appartenant à la même colonne $C_k$ sont interconnectés via une ligne de bits commune notée $BL_k$.

Avantageusement et sans perte de généralité, dans chaque plan mémoire $P_i$, les cellules mémoires CM d'une colonne $C_k$ d'ordre impair partagent la même ligne de source avec les cellules mémoire de la colonne adjacente suivante $C_{k+1}$ d'ordre pair. À titre d'exemple non limitatif, chaque cellule mémoire CM d'une colonne $C_k$ d'ordre impair reçoit via une ligne de bits $BL_k$ un signal de commande $VBL_k$ complémentaire à celui de la cellule mémoire de la colonne adjacente suivante $C_{k+1}$ d'ordre pair, noté $VBL_{kb}$ sur la ligne de bits $BL_{kb}$. Cette architecture offre l'avantage d'une structure tridimensionnelle plus compacte avec une optimisation du nombre de lignes de bits et lignes de sources.

Les lignes de sélection $WL_{ij}$ sont indépendantes les unes des autres. Lorsqu'une opération logique est réalisée en parallèle sur tous les plans (YZ), n'importe quelle cellule mémoire peut être ouverte ou fermée grâce à un nœud de sélection indépendant $WL_{ij}$. Les lignes de sélection $WL_{ij}$ sont indépendantes à l'intérieur d'un même plan (YZ), toutes les cellules inutilisées pendant une opération logique seront fermées. Cela permet de limiter les courants de fuite dans les colonnes de rang j à travers tous les plans mémoire $P_i$.

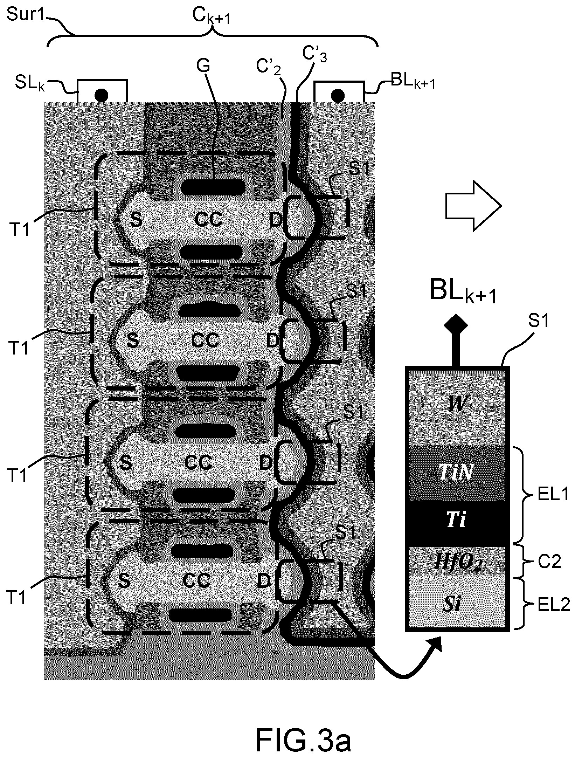

La figure 3a illustre une vue en coupe d'un mode de réalisation de la structure en couches minces d'une colonne $C_{k+1}$ de quatre cellules mémoires CM d'une structure mémoire tridimensionnelle 10 selon l'invention. Les matériaux utilisés sont présentés à titre d'illustration non limitative.

La colonne $C_{k+1}$ comprend un premier pilier métallique pour réaliser la ligne de source commune $SL_k$ et un second pilier métallique pour réaliser la ligne d'intersection commune $BL_{kb}$. La colonne comprend en outre un empilement de quatre transistors indépendants de type grille enrobante (Gate-All-Around en anglais) séparés par un matériau isolant. Chaque transistor correspond au transistor de sélection T1 d'une cellule mémoire. Chaque transistor comprend un canal de conduction CC en silicium ayant une première extrémité correspondant au drain et une seconde extrémité correspondant à la source. L'utilisation des transistors de type grille enrobante permet de réduire considérablement les courants de fuite de la structure. De plus, les transistors de type grille enrobante présentent la possibilité d'être empilés les uns au-dessus des autres afin de réaliser une structure dense selon l'invention. La paroi latérale du côté des drains de l'ensemble des transistors est recouverte d'une succession de couches. La succession de couches comprend dans cet ordre une première couche en un matériau diélectrique C'2 tel que l'oxyde de hafnium ($HfO_2$), puis une première couche métallique C'3 en Titane (Ti), puis une deuxième couche métallique en nitrure de titane (TiN) par exemple. La succession de couches obtenue au niveau de chaque drain d'un transistor T1 forme une structure de stockage résistive S1 correspondant à l'empilement de la figure 1a. L'électrode supérieure EL1 se compose de l'ensemble de la première couche métallique en Titane et la deuxième couche métallique en nitrure de titane. La couche centrale C2 est la couche en oxyde de hafnium. L'électrode inférieure EL2 correspond à l'extrémité du canal du transistor T1. Avantageusement, il est envisageable de déposer une couche métallique supplémentaire entre l'extrémité du canal du transistor T1 et la première couche en un matériau diélectrique C'2 pour améliorer le contact électrique au niveau de l'électrode inférieure EL2.

Un transistor T1 et la structure de stockage résistive S1 qui lui est connectée forment ensemble une cellule mémoire CM selon l'invention. On réalise ainsi un empilement de quatre cellules mémoires CM.

La colonne $C_{k+1}$ est obtenue par la réalisation de l'agencement suivant : le premier pilier métallique $SL_k$ en contact avec toutes les secondes extrémités correspondant à la source ; et le second pilier métallique $BL_{kb}$ mis en contact avec l'ensemble des électrodes supérieures EL1.

Le premier pilier métallique $SL_k$ se propage jusqu'à la face supérieure Sur1 de la structure mémoire tridimensionnelle 10 afin de former premier connecteur associé. Le second pilier métallique $BL_{k+1}$ se propage jusqu'à la face supérieure Sur1 de la structure mémoire tridimensionnelle 10 afin de former second connecteur associé. Les connecteurs au niveau de la surface supérieure constituent les points d'accès aux lignes de bits et lignes de source afin d'appliquer les tensions de commande VBL et VSL lors d'une lecture et/ou écriture d'une cellule mémoire CM sélectionnée.

La structure présentée dans la figure 3a permet d'implémenter physiquement le circuit selon l'invention avec une densité géométrique améliorée par rapport aux mémoires non volatiles de type NOR connues. Plus particulièrement, la structure mémoire 10 permet d'implémenter une pluralité de cellules mémoires de type 1T1R (un transistor et une résistance) avec une structure tridimensionnelle plus compacte par rapport aux solutions connues.

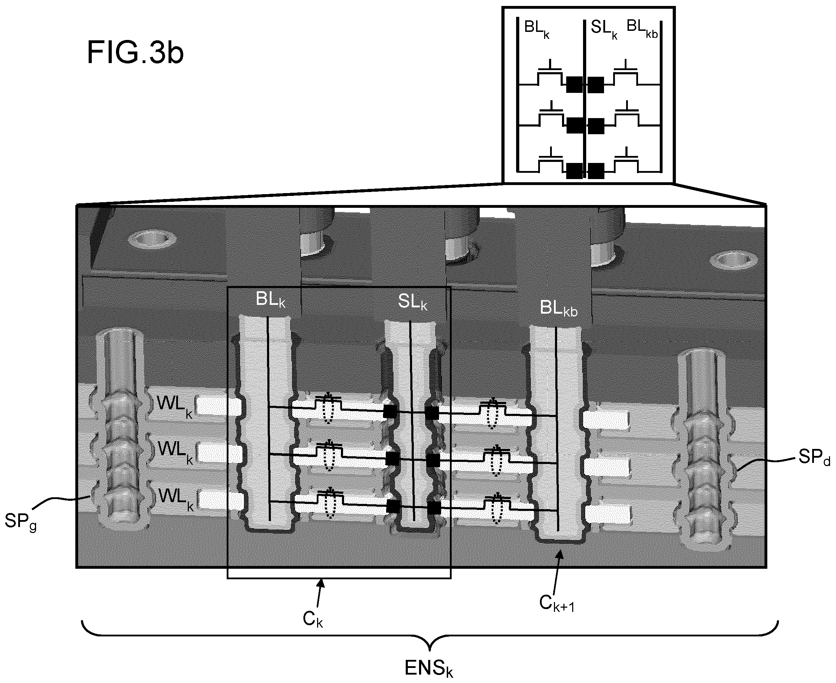

La figure 3b illustre une vue en coupe de la structure en couches minces de deux colonnes adjacentes $C_k$ et $C_{k+1}$ d'un même plan mémoire $P_i$ et partageant une ligne de source commune $SL_k$. Les deux colonnes adjacentes présentent alors un pilier de connexion commun correspondant à la ligne de source commune $SL_k$. L'ensemble formé par ces deux colonnes $C_k$ et $C_{k+1}$ est noté $ENS_k$. L'ensemble $ENS_k$ est délimité de chaque côté, par un pilier de délimitation gauche $SP_g$ et un pilier de délimitation droit $SP_d$. Ainsi, chaque plan mémoire $P_i$ est composé d'une répétition d'ensembles $ENS_k$ séparés par des piliers de délimitation remplis par un matériau diélectrique.

Dans l'exemple illustré, chaque colonne comprend un empilement de trois cellules mémoires. Ainsi, chaque ensemble $ENS_k$ comprend six cellules mémoires CM, deux piliers de délimitation $SP_g$ et $SP_d$, trois piliers de connexion $BL_k$ , $SL_k$ et $BL_{kb}$ qui débouchent sur trois connecteurs, et trois pistes de sélection $WL_1$ à $WL_3$.

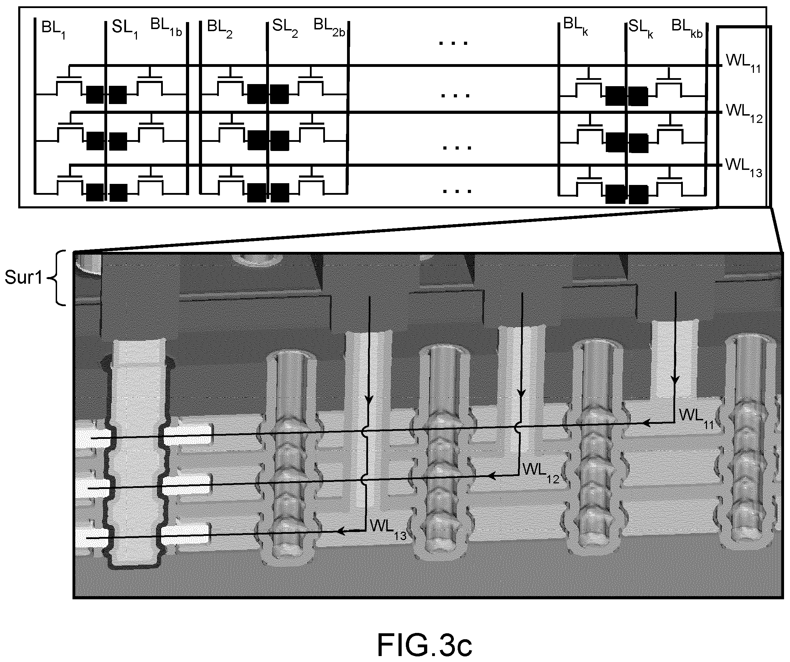

La figure 3c illustre une vue en coupe de la structure en couches minces des piliers de connexion des signaux de sélection d'un même plan mémoire $P_i$. Il convient de rappeler que pour chaque plan $P_i$, un signal de sélection $VWL_{ij}$ est propagé pour chaque ligne du plan $L_j$. La propagation de chaque signal de sélection $VWL_{ij}$ est réalisée par une piste de sélection métallique qui traverse le plan $P_i$ horizontalement. L'accès électrique à chaque piste de sélection, est réalisé par un pilier de sélection dédié. Chaque pilier de sélection est un pilier métallique qui se propage verticalement reliant la piste horizontale associée à un connecteur situé sur la surface supérieure Sur1. On obtient ainsi pour chaque plan mémoire $P_i$ trois connecteurs. La différence de niveau entre les pistes horizontales de sélection induit une structure en escalier formée par les piliers.

Avantageusement, les piliers des signaux de sélection $VWL_{ij}$ sont séparés l'un de l'autre par des piliers de délimitation semblables à ceux décrits préalablement.

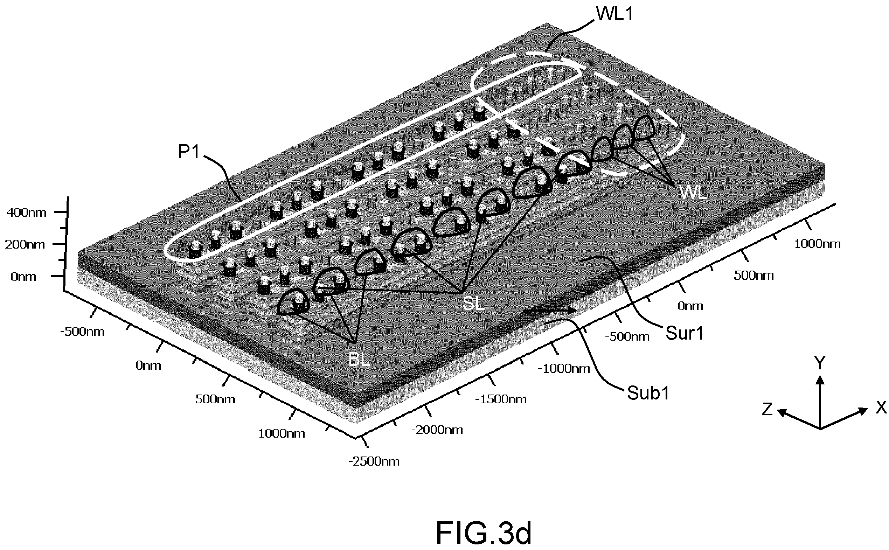

La figure 3d illustre une vue en perspective de la structure mémoire tridimensionnelle 10 utilisée dans le circuit de stockage selon l'invention. La structure matricielle 3D est réalisée sur un substrat semiconducteur SUB1. La surface supérieure Surf1 comprend une pluralité de connecteurs SL, BL et WL. Les connecteurs sont distribués selon plusieurs rangées selon l'axe X. Chaque rangée de connecteurs correspond à un plan mémoire $P_i$ de rang i. À l'extrémité de chaque ligne de connecteurs, on trouve M=3 connecteurs de sélection WL. Le nombre de connecteurs de sélection WL correspond au nombre de lignes $L_j$ d'un plan mémoire. Pour chaque rangée, les connecteurs sont répartis selon la répétition du triplet $BL_k$, $SL_k$, $BL_{k+1}$ correspondant aux accès électriques aux lignes d'un ensemble de cellules mémoire $ENS_k$. On observe que les triplets sont séparés par les extrémités par des piliers de délimitations apparentes sur la surface supérieure Sur1.

Nous avons ainsi, décrit la répartition des connecteurs BL, SL et WL des cellules mémoire de la structure tridimensionnelle mémoire 20. Les connecteurs représentent les accès électriques pour appliquer les signaux de commande et de sélection lors d'une opération de lecture et d'écriture de l'une quelconque des cellules mémoire $CM_{ijk}$ , avec i le rang du plan mémoire $P_i$, j le rang de la ligne $L_j$ de la cellule mémoire $L_j$, et k le rang de sa colonne $C_k$. Chaque cellule $CM_{ijk}$ mémoire est sélectionnable par le connecteur associé à son nœud de sélection $WL_{ij}$. L'écriture et la lecture de la cellule mémoire $CM_{ijk}$ est réalisée par l'application d'une première tension VSL sur son premier connecteur associé $SL_{ik}$ et l'application d'une seconde tension VBL sur son second connecteur associé $BL_{ik}$.

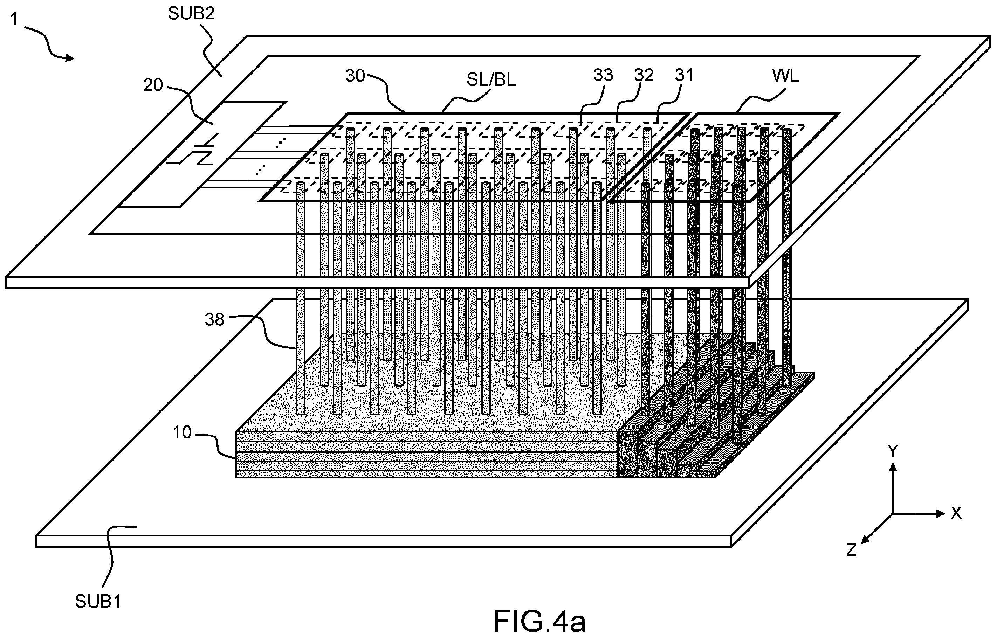

La figure 4a illustre une vue en perspective du circuit de stockage 1 selon l'invention. Le circuit de stockage de données 1 comprend la structure mémoire tridimensionnelle 10 décrite, un circuit de contrôle 20 et une structure d'interconnexion 30. Le circuit de contrôle 20 est configuré pour appliquer des tensions de commande VBL, VSL et VWL sur les nœuds de chaque cellule mémoire. La structure d'interconnexion 3 est destinée à connecter le circuit de contrôle 20 à la structure mémoire tridimensionnelle 10 à travers les connecteurs au niveau de la surface supérieure Sur1 de ladite structure 10.

Le circuit de contrôle 20 est un circuit intégré de type CMOS réalisé sur la face supérieure d'un second substrat semiconducteur SUB2. La face inférieure du second substrat semiconducteur SUB2 est superposée à la surface supérieure Sur1 de la structure mémoire tridimensionnelle 10. On obtient ainsi un empilement selon l'axe Y formé par la structure mémoire tridimensionnelle 10 et le circuit de contrôle 20. La réalisation sur deux substrats semiconducteurs distincts présente plusieurs avantages :

- L'amélioration de la densité spatiale du circuit de stockage ;

- La possibilité d'implémenter le circuit de contrôle par des transistors CMOS à des noeuds technologiques avancés (<28 nm). Car il est difficile d'implémenter des transistors de ce type sur le même substrat supportant la structure mémoire tridimensionnelle 10. Cette difficulté s'explique par les facteurs suivants : les transistors de sélection intégrés dans la structure tridimensionnelle sont optimisés pour la densité, et non pour la performance logique. Le procédé de fabrication sur un même substrat impose la construction de chaque transistor du circuit de contrôle selon la même structure des transistors de sélection de la structure tridimensionnelle. Cela implique une réduction considérable de performance du circuit de contrôle par rapport à l'utilisation des transistors à nœud technologique avancé ; et

- L'établissement d'une connexion verticale (selon Y) et non horizontale (selon le plan du premier substrat SUB1). Cela permet la réduction du nombre de niveaux de pistes métalliques nécessaires pour connecter le circuit de contrôle 20 à la structure mémoire tridimensionnelle 10.

Il a été déjà établi que l'accès électrique à chaque nœud BL, SL et WL d'une cellule mémoire $CM_{ijk}$ se fait via les connecteurs répartis sur la surface supérieure Sur1. La structure d'interconnexion 30 permet d'établir la connexion électrique entre les connecteurs de la structure mémoire 10 et le circuit de contrôle 20 dans la configuration d'empilement décrite. La structure d'interconnexion 30 est une interface confinée entre la structure mémoire 10 et le circuit de contrôle 20. La structure d'interconnexion 30 comprend une pluralité de plots de connexions 31, 32, 33 (Bonding Pad en Anglais) disposées entre le circuit de contrôle 20 et ladite surface supérieure Sur1. Les plots de connexions 31, 32, 33 sont des couches métalliques qui s'étendent selon un plan parallèle à la surface supérieure Sur1 avec une épaisseur comprise entre 10nm et 500nm.

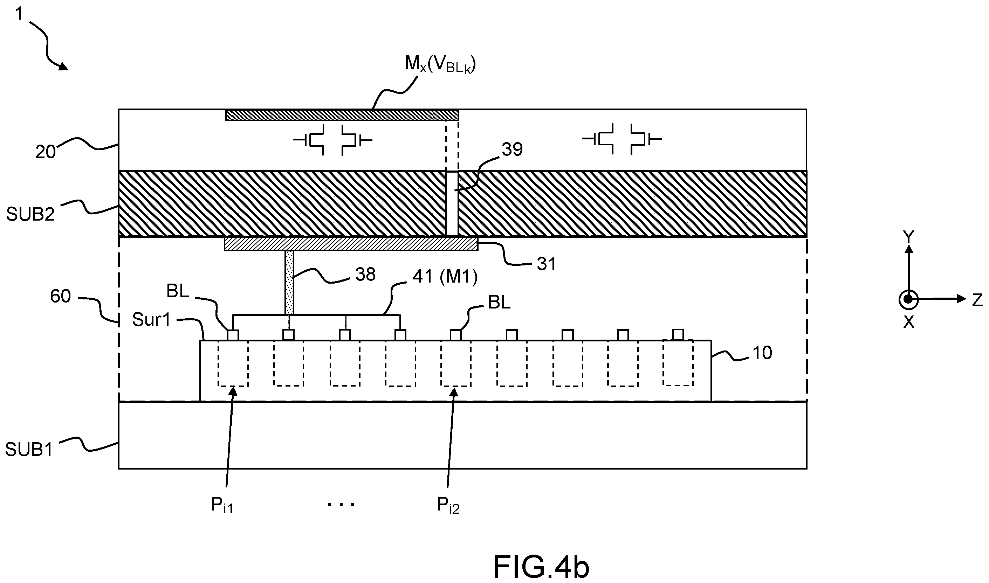

Afin de mieux comprendre l'implémentation physique de la structure d'interconnexion 30, la figure 4b illustre une vue en coupe partielle du circuit de stockage 1 représentant un plot de connexion 31 selon un premier mode de réalisation. Nous allons illustrer une seule connexion par souci de simplification de l'illustration sans perte de généralité.

Afin de propager un signal de commande $VBL_{k1}$ fourni du circuit de contrôle 20 vers au moins un premier nœud d'entrée/sortie $BL_{k1}$ associé, la structure d'interconnexion 30 comprend : un premier via 39 traversant le second substrat semiconducteur SUB2 pour transmettre le signal de commande $VBL_{k1}$ ; un plot de connexion 31 disposé entre le second substrat semiconducteur SUB2 et ladite surface supérieure Sur1 ; un second via 38 reliant le plot de connexion 31 à une piste de connexion 41 horizontale. La piste de connexion 41 horizontale est déposée sur la surface supérieure Sur1. Le premier via 39 est un via de type TSV (acronyme Through Silicon Via). Il se propage jusqu'au niveau de métal supérieur Mx du circuit de contrôle 20. Ce mode de réalisation correspond à un assemblage de type « Back-to-Face » car l'interface d'assemblage est entre la surface supérieure Sur1 de la structure mémoire tridimensionnelle 10 et la face inférieure du second substrat SUB2.

Dans le cadre de l'invention, un plot de connexion 31 est commun à une pluralité de cellules mémoires CM appartenant à plusieurs plans successifs $P_{i1}$ à $P_{i2}$ (i1<i2) et appartenants à des colonnes $C_k$ de même rang k. La mise en commun de plots de connexion 31 est réalisée par la piste de connexion 41 horizontale.

Avantageusement, la structure mémoire tridimensionnelle 10 est encapsulée dans une couche diélectrique 60. Le plot de connexion est disposé sur la couche diélectrique 60 de manière à établir une connexion électrique avec le second via 38. Le second via 38 traverse la couche diélectrique 60 jusqu'à la piste métallique 41 et/ou un connecteur au niveau de la surface supérieure Sur1.

L'assemblage par empilement du circuit de contrôle 20 à la structure mémoire tridimensionnelle 10 est réalisé par la technique de « collage hybride ». On entend par collage hybride un collage direct simultané de type métal-métal et de type diélectrique-diélectrique. En exploitant la conductivité du métal et le caractère isolant du diélectrique, le collage hybride sert à fabriquer une pluralité de plots de connexion. Avant l'assemblage, la face inférieure est manufacturée de manière à obtenir une surface en diélectrique comprenant un premier groupe de plots métalliques. De même, la surface supérieure de la couche diélectrique 60 d'encapsulation comprend un second groupe de plots métalliques ayant les mêmes coordonnées planaires de celles du premier groupe. Ensuite, un collage hybride est utilisé pour réaliser l'assemblage 3D tout en créant les interconnexions au niveau des plots de connexions 31, 32 et 33. A titre d'exemple non limitatif, les plots de connexions 31, 32 et 33 sont des plots en cuivre et le collage hybride est de type Cuivre-Cuivre et $SiO_2$-$SiO_2$.

La même structure décrite préalablement reste valable pour la réalisation de connexions associées aux premiers nœuds d'entrée/sortie SL et aux nœuds de sélection WL.

Les plots de connexions 31, 32 et 33 doivent être distincts les uns des autres pour éviter les courts-circuits et doivent être placés en même temps au plus près des cellules mémoire associées pour améliorer la performance des opérations de lecture et écriture. Ainsi, il est nécessaire de bien optimiser la distribution spatiale des plots de connexions 31 par rapport à la surface supérieure Sur1.

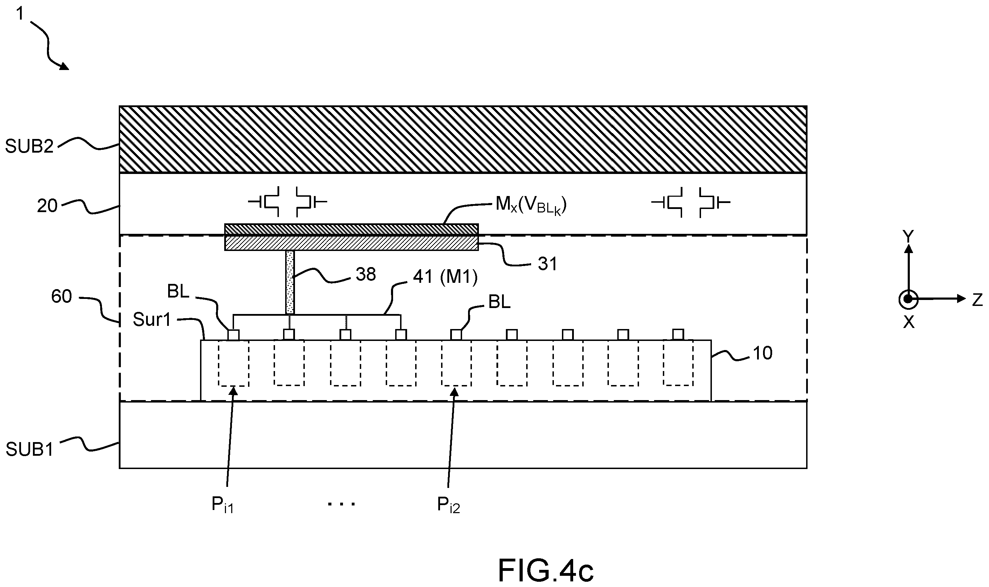

Alternativement, la figure 4c illustre une vue en coupe partielle du circuit de stockage 1 représentant un plot de connexion 31 selon un second mode de réalisation. Nous allons illustrer une seule connexion par souci de simplification de l'illustration sans perte de généralité. Le second mode de réalisation correspond à un assemblage de type « Face-to-Face ». En effet, l'interface d'assemblage est entre la surface supérieure Sur1 de la structure mémoire tridimensionnelle 10 et la face supérieure du circuit de contrôle 20. Plus particulièrement chaque plot de connexions 31, 32 et 33 est assemblé à une couche métallique du niveau métallique supérieur Mx du circuit de contrôle 20 par la technique de collage hybride décrite précédemment. Dans ce mode de réalisation il n'y a pas besoin d'utiliser un via 39 traversant la totalité du substrat SUB2 pour établir la connexion électrique entre le circuit de contrôle 20 et un plot de connexion 31. Cette connexion est réalisée directement par l'assemblage par collage hybride en respectant l'alignement entre le plot de connexion et la couche métallique du niveau métallique supérieur Mx du circuit de contrôle 20 associée.

Ce mode de réalisation permet de s'affranchir des contraintes imposées par les vias de type TSV et ainsi améliorer la densité de la structure assemblée.

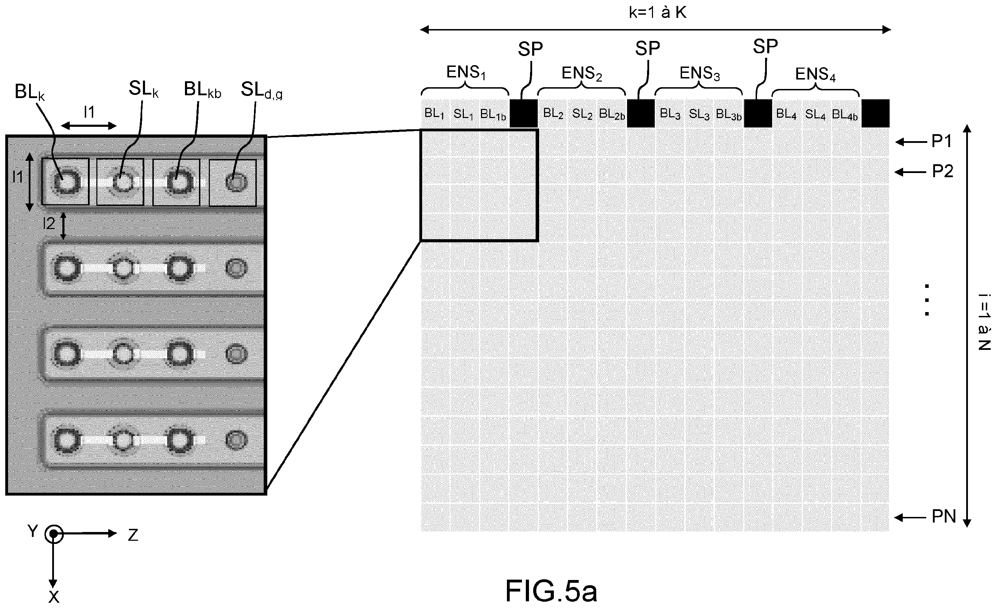

Les figures 5a - 5 e sont destinées à illustrer des configurations de distribution spatiale des plots de connexions 31, 32 et 33 selon plusieurs modes de réalisation de l'invention.

La figure 5a illustre une vue de dessus d'un découpage de la surface supérieure Sur1 de la structure mémoire tridimensionnelle 20 avant le placement des plots de connexion 31. On prend à titre d'exemple non limitatif, la structure mémoire tridimensionnelle 10 de la figure 3d organisée en triplets $BL_k$, $SL_k$, $BL_{kb}$ correspondant aux accès électrique aux lignes d'un ensemble de cellules mémoire $ENS_k$ Les ensembles de cellules mémoire $ENS_k$ sont séparés par l'extrémité des piliers de délimitations apparents sur la surface supérieure Sur1. Il s'agit d'une vue selon le plan (X,Z) dans le référentiel orthonormé préalablement utilisé. La surface supérieure Sur1 peut être découpée en plusieurs zones rectangulaires à surface égale. Chaque zone rectangulaire est centrée à un connecteur associé ou à l'extrémité apparente d'un pilier de délimitation associé.

Chaque ligne de la matrice formée par les zones rectangulaires illustrées présente un plan mémoire $P_i$. Les connecteurs adjacents appartenant à un même plan mémoire $P_i$ sont séparés l'un de l'autre d'une première distance $I_1$. Les plans mémoire $P_i$ adjacents sont séparés l'un de l'autre d'une seconde distance $I_2$. En parcourant la matrice formée par les zones rectangulaires, on obtient un pas horizontal (selon l'axe X) égal à la première distance $I_1$ et un pas vertical (selon l'axe Z) égal à $I_1$ + $I_2$. Selon ce découpage, chaque zone rectangulaire couvre une colonne de M cellules mémoires.

A titre d'exemple, la première distance $I_1$ est égale à 160 nm et la seconde distance $I_2$ est égale à 100nm ce qui donne une zone rectangulaire de 0,0416 $\mu m^2$.

Après l'introduction du découpage spatial de la surface supérieure, la section suivante est consacrée à la description de la distribution des plots de connexions sur cette surface selon l'invention.

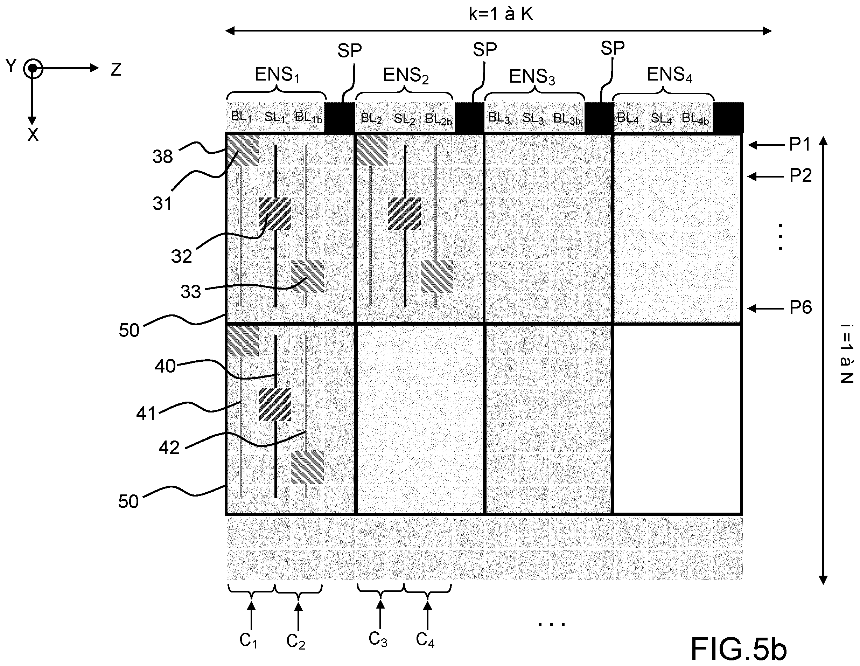

La figure 5b illustre une vue de dessus de la structure mémoire tridimensionnelle illustrant la distribution des plots de connexion 31 selon un premier mode de réalisation de l'invention. Dans ce mode de réalisation, on suppose que l'aire d'un plot de connexion est égale à celle d'une zone rectangulaire du découpage précédent.

La pluralité de plots de connexion est formée par la répétition périodique d'un motif unitaire 50. Dans le cas illustré, chaque motif unitaire 50 couvre deux colonnes consécutives $C_k$ et $C_{k+1}$ de cellules mémoire CM appartenant à six plans mémoires $P_i$. Chaque colonne $C_k$ comprend M cellules mémoires. Ainsi, chaque motif unitaire 50 couvre un groupe élémentaire 51 de cellules mémoires. Un motif unitaire 50 couvre une sous-matrice de 6 lignes et 4 piliers selon le découpage de la figure 5a (6x4 régions rectangulaires)

Dans le mode de réalisation illustré, chaque groupe élémentaire 51 comprend alors « M*2 colonnes*6 plans mémoire » cellules mémoires $CM_{ijk}$ pour trois plots de connexions 31, 32 et 33. Les plots de connexion coïncident avec leurs vias (représentés en hachurés) traversants vers les connecteurs.

Le premier plot de connexion 31 est connecté au connecteur $BL_k$ de la cellule mémoire de la première colonne du groupe élémentaire 51 et appartenant au plan initial $P_{i1}$ du groupe élémentaire 51. Le premier plot de connexion 31 est placé dans la zone de coordonnée (1,1) dans la sous-matrice correspondant au motif unitaire 50. Les seconds nœuds d'entrée/sortie BL des cellules mémoires appartenant à la première colonne sont interconnectés via la piste métallique 41.

Le deuxième plot de connexion 32 est connecté au connecteur $SL_k$ des cellules mémoire du troisième plan $P_{i1+2}$ du groupe élémentaire 51. Le deuxième plot de connexion 31 est placé dans la zone de coordonnée (3,2) dans la sous-matrice correspondant au motif unitaire 50. Les premiers nœuds d'entrée/sortie SL des cellules mémoires appartenant à l'ensemble du motif unitaire 50 sont interconnectés via la piste métallique 40.

Le troisième plot de connexion 32 est connecté au connecteur $BL_{k+1}$ de la cellule mémoire de la deuxième colonne du groupe élémentaire 51 et appartenant à l'avant dernier plan $P_{i1+4}$ du groupe élémentaire 51. Le troisième plot de connexion 31 est placé dans la zone de coordonnée (5,3) dans la sous-matrice correspondant au motif unitaire 50. Les seconds nœuds d'entrée/sortie BL des cellules mémoires appartenant à la deuxième colonne sont interconnectés via la piste métallique 42.

Grâce à la distribution optimisée des plots de connexion décrite ci-dessus, il est possible de réaliser une architecture mémoire de type NOR. En effet, la structure d'interconnexion décrite permet d'optimiser l'accès aux différentes cellules mémoire de manière à augmenter le parallélisme par rapport à un routage sur la structure tridimensionnelle directement. Il en résulte qu'il est possible de réaliser des opérations de lecture et d'écriture d'une manière indépendante dans chaque groupe élémentaire 51 correpondant à un motif unitaire. Cela permet de réaliser des opérations de lecture et d'écriture en parallèle grâce à cette indépendance. L'augmentation du parallélisme permet de s'affranchir des contraintes de l'état de l'art et plus spécifiquement les contraintes d'une structure en NAND. En effet, dans une structure en NAND, le fonctionnement des cellules mémoires est interdépendant dans la structure tridimensionnelle, nécessitant l'application de signaux d'inhibition pour éviter des opérations d'écriture ou de lecture non désirées. De plus, l'accès séquentiel dans une structure NAND implique la polarisation de tous les transistors en série pour les rendre passant et accéder à la cellule mémoire cible. Ainsi, la structure NOR 3D selon l'invention et la connectivité proposée permettent de combiner en même temps la compacité d'une structure 3D avec le parallélisme d'opérations d'une structure mémoire NOR. Ainsi, la structure selon l'invention présente un aces direct pour chaque nœud d'entrée sortie BL,SL et chaque nœud de sélection WL.

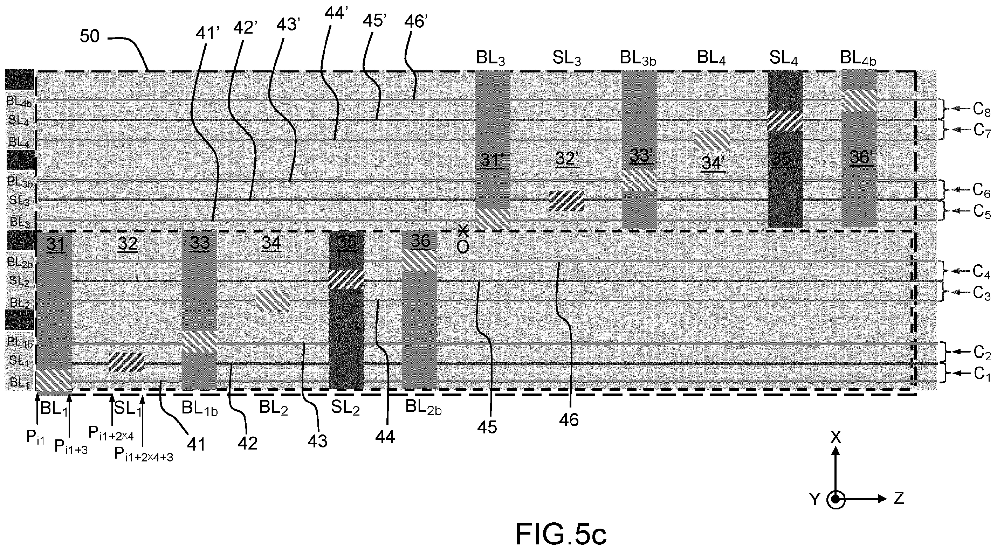

La figure 5c illustre une vue de dessus de la structure mémoire tridimensionnelle illustrant la distribution des plots de connexion 31 selon un second mode de réalisation de l'invention. Dans ce mode de réalisation, on suppose que l'aire d'un plot de connexion est supérieure à celle d'une zone rectangulaire du découpage précédent. Autrement dit, en coupe horizontale, l'aire d'un plot de connexion est supérieure à l'aire d'un via inférieur 38.

A titre d'exemple illustratif et non limitatif, on considère qu'un plot de connexion est un carré de côté $e=1\mu m$ et ainsi, l'aire d'un plot est égale à $1\mu m^2$. On considère qu'une zone rectangulaire du découpage de la surface supérieure présente les dimensions suivantes : la première distance $l_1$ est égale à 160 nm et la seconde distance $l_2$ est égale à 100nm ce qui donne une zone rectangulaire de 0,0416 $\mu m^2$. Ainsi, chaque plot de connexion couvre une surface correspondant à quatre plans mémoire $P_i$ (selon l'axe z) et quatre colonnes $C_n$ (selon l'axe x) correspondant à 8 zones rectangulaires du découpage. Les plots de connexion doivent être espacés d'une distance équivalente à quatre plans mémoire $P_i$ (selon l'axe z). La distribution illustrée correspond à un motif de distribution optimal permettant de respecter les contraintes suivantes :

- Une surface des plots de connexion de l'ordre du $\mu m^2$ ;

- Un espacement entre les plots de connexion supérieur ou égal à la côté d'un plot de connexion.

Le motif unitaire des plots de connexion selon l'invention doit présenter une aire minimale tout en respectant les contraintes précitées. La minimisation de l'aire du motif unitaire permet de maximiser le nombre de groupes élémentaires associés. Ainsi, la connectivité de chaque groupe élémentaire de cellule mémoire est indépendante de celle des autres groupes élémentaires. Cela implique une augmentation du parallélisme des opérations de lecture et d'écriture dans le circuit de stockage de données.

Dans le mode de réalisation illustré, le motif unitaire 50 couvre un groupe élémentaire 51 de cellules mémoires comprenant « M*6 colonnes*96 plans » cellules mémoires $CM_{ijk}$ pour 12 plots de connexions 31 à 36 et 31' à 36. Les plots de connexion sont plus larges que les vias (représentés en hachurés) traversants vers les connecteurs.

Le premier plot de connexion 31 est connecté au connecteur $BL_1$ des cellules mémoires de la première colonne du groupe élémentaire 51 et appartenant aux 4 premiers plans mémoires $P_{i1}$ à $P_{i1+3}$ du groupe élémentaire 51. La connexion est réalisée par un via (en hachuré) traversant jusqu'aux connecteurs des nœuds d'entrée/sortie BL des cellules mémoire précités. Les seconds nœuds d'entrée/sortie BL des cellules mémoires appartenant à la première colonne $C_1$ des 96 plans mémoires du groupe élémentaire 51 sont interconnectés via la piste métallique 41.

Le deuxième plot de connexion 32 est connecté au connecteur $SL_1$ des cellules mémoires de la première colonne du groupe élémentaire 51 et appartenant aux 4 plans mémoires $P_{i1+2x4}$ à $P_{i1+2*4+3}$ du groupe élémentaire 51. La connexion est réalisée par un via (en hachuré) traversant jusqu'aux connecteurs des nœuds d'entrée/sortie SL des cellules mémoire précités. Les premiers nœuds d'entrée/sortie SL des cellules mémoires appartenant à la première colonne $C_1$ des 96 plans mémoires du groupe élémentaire 51 sont interconnectés via la piste métallique 42.

Le troisième plot de connexion 33 est connecté au connecteur $BL_{1b}$ des cellules mémoires de la deuxième colonne $C_2$ du groupe élémentaire 51 et appartenant aux 4 plans mémoires $P_{i1+4x4}$ à $P_{i1+4*4+3}$ du groupe élémentaire 51. La connexion est réalisée par un via (en hachuré) traversant jusqu'aux connecteurs des nœuds d'entrée/sortie BL des cellules mémoire précités. Les seconds nœuds d'entrée/sortie BL des cellules mémoires appartenant à la deuxième colonne $C_2$ des 96 plans mémoires du groupe élémentaire 51 sont interconnectés via la piste métallique 43.

Le quatrième plot de connexion 34 est connecté au connecteur $BL_2$ des cellules mémoires de la troisième colonne $C_3$ du groupe élémentaire 51 et appartenant aux 4 plans mémoires $P_{i1+6x4}$ à $P_{i1+6*4+3}$ du groupe élémentaire 51. La connexion est réalisée par un via (en hachuré) traversant jusqu'aux connecteurs des nœuds d'entrée/sortie BL des cellules mémoire précités. Les seconds nœuds d'entrée/sortie BL des cellules mémoires appartenant à la troisième colonne $C_3$ des 96 plans mémoires du groupe élémentaire 51 sont interconnectés via la piste métallique 44.

Le cinquième plot de connexion 35 est connecté au connecteur $SL_2$ des cellules mémoires de la troisième colonne $C_3$ du groupe élémentaire 51 et appartenant aux 4 plans mémoires $P_{i1+8x4}$ à $P_{i1+8*4+3}$ du groupe élémentaire 51. La connexion est réalisée par un via (en hachuré) traversant jusqu'aux connecteurs des nœuds d'entrée/sortie SL des cellules mémoire précités. Les premiers nœuds d'entrée/sortie SL des cellules mémoires appartenant à la troisième colonne $C_3$ des 96 plans mémoires du groupe élémentaire 51 sont interconnectés via la piste métallique 45.

Le sixième plot de connexion 36 est connecté au connecteur $BL_{2b}$ des cellules mémoires de la quatrième colonne $C_4$ du groupe élémentaire 51 et appartenant aux 4 plans mémoires $P_{i1+10x4}$ à $P_{i1+10*4+3}$ du groupe élémentaire 51. La connexion est réalisée par un via (en hachuré) traversant jusqu'aux connecteurs des nœuds d'entrée/sortie BL des cellules mémoire précités. Les seconds nœuds d'entrée/sortie BL des cellules mémoires appartenant à la quatrième colonne $C_4$ des 96 plans mémoires du groupe élémentaire 51 sont interconnectés via la piste métallique 46.

Le septième plot de connexion 31' est connecté au connecteur $BL_3$ des cellules mémoires de la cin-quième colonne $C_5$ du groupe élémentaire 51 et appartenant aux 4 plans mémoires $P_{i1+12x4}$ à $P_{i1+12*4+3}$ du groupe élémentaire 51. La connexion est réalisée par un via (en hachuré) traversant jusqu'aux connecteurs des nœuds d'entrée/sortie BL des cellules mémoire précités. Les seconds nœuds d'entrée/sortie BL des cellules mémoires appartenant à la cinquième colonne $C_5$ des 96 plans mémoires du groupe élémentaire 51 sont interconnectés via la piste métallique 41'.

Le huitième plot de connexion 32' est connecté au connecteur $SL_3$ des cellules mémoires de la cin-quième colonne $C_5$ du groupe élémentaire 51 et appartenant aux 4 plans mémoires $P_{i1+14x4}$ à $P_{i1+14*4+3}$ du groupe élémentaire 51. La connexion est réalisée par un via (en hachuré) traversant jusqu'aux connecteurs des nœuds d'entrée/sortie SL des cellules mémoire précités. Les premiers nœuds d'entrée/sortie SL des cellules mémoires appartenant à cinquième colonne $C_5$ des 96 plans mémoires du groupe élémentaire 51 sont interconnectés via la piste métallique 42'.

Le neuvième plot de connexion 33' est connecté au connecteur $BL_{3b}$ des cellules mémoires de la sixième colonne $C_6$ du groupe élémentaire 51 et appartenant aux 4 plans mémoires $P_{i1+16x4}$ à $P_{i1+16*4+3}$ du groupe élémentaire 51. La connexion est réalisée par un via (en hachuré) traversant jusqu'aux connecteurs des nœuds d'entrée/sortie BL des cellules mémoire précités. Les seconds nœuds d'entrée/sortie BL des cellules mémoires appartenant à la sixième colonne $C_6$ des 96 plans mémoires du groupe élémentaire 51 sont interconnectés via la piste métallique 43'.

Le dixième plot de connexion 34' est connecté au connecteur $BL_4$ des cellules mémoires de la septième colonne $C_7$ du groupe élémentaire 51 et appartenant aux 4 plans mémoires $P_{i1+18x4}$ à $P_{i1+18*4+3}$ du groupe élémentaire 51. La connexion est réalisée par un via (en hachuré) traversant jusqu'aux connecteurs des nœuds d'entrée/sortie BL des cellules mémoire précités. Les seconds nœuds d'entrée/sortie BL des cellules mémoires appartenant à la septième colonne $C_7$ des 96 plans mémoires du groupe élémentaire 51 sont interconnectés via la piste métallique 44'.

Le onzième plot de connexion 35' est connecté au connecteur $SL_4$ des cellules mémoires de la septième colonne $C_7$ du groupe élémentaire 51 et appartenant aux 4 plans mémoires $P_{i1+20x4}$ à $P_{i1+20*4+3}$ du groupe élémentaire 51. La connexion est réalisée par un via (en hachuré) traversant jusqu'aux connecteurs des nœuds d'entrée/sortie SL des cellules mémoire précités. Les premiers nœuds d'entrée/sortie SL des cellules mémoires appartenant à la septième colonne $C_7$ des 96 plans mémoires du groupe élémentaire 51 sont interconnectés via la piste métallique 45'.

Le douzième plot de connexion 36' est connecté au connecteur $BL_{4b}$ des cellules mémoires de la huitième colonne $C_8$ du groupe élémentaire 51 et appartenant aux 4 plans mémoires $P_{i1+22x4}$ à $P_{i1+22*4+3}$ du groupe élémentaire 51. La connexion est réalisée par un via (en hachuré) traversant jusqu'aux connecteurs des nœuds d'entrée/sortie BL des cellules mémoire précités. Les seconds nœuds d'entrée/sortie BL des cellules mémoires appartenant à la huitième colonne $C_8$ des 96 plans mémoires du groupe élémentaire 51 sont interconnectés via la piste métallique 46'.

Les plots de connexions 31' à 36' sont symétriques aux plots de connexions 31 à 36 par rapport au centre O du motif unitaire 50. Il s'agit d'une symétrie centrale entre deux groupes de plots, les deux groupes étant identiques en nombre et en forme. Cet arrangement permet d'obtenir une meilleure densité spatiale des plots de connexion.

D'une manière générale, selon l'axe z les plots de connexion sont périodiquement répétés par avec une période égale à 2 fois le nombre de plans mémoire couverts par un plot de connexion. Soit x1 le nombre de triplets $ENS_k$ couvert par la surface d'un plot de connexion selon l'axe x. Les plots de connexion sont répartis sur des groupes de 3*x1 plots.Chaque groupe de 3*x1 plots de connexion est aligné avec les colonnes $C_k$ associées aux ensembles $ENS_k$ dédiés. Dans le cas illustré on utilise 6 plots 31 à 36 pour accéder aux cellules mémoire de 2 triplets $ENS_1$ et $ENS_2$. L'ordre entre les plots de connexion appartenant au même groupe est présenté ici à titre d'exemple. Il est possible d'interchanger les positions selon l'axe Z des plots de connexion d'un même groupe.

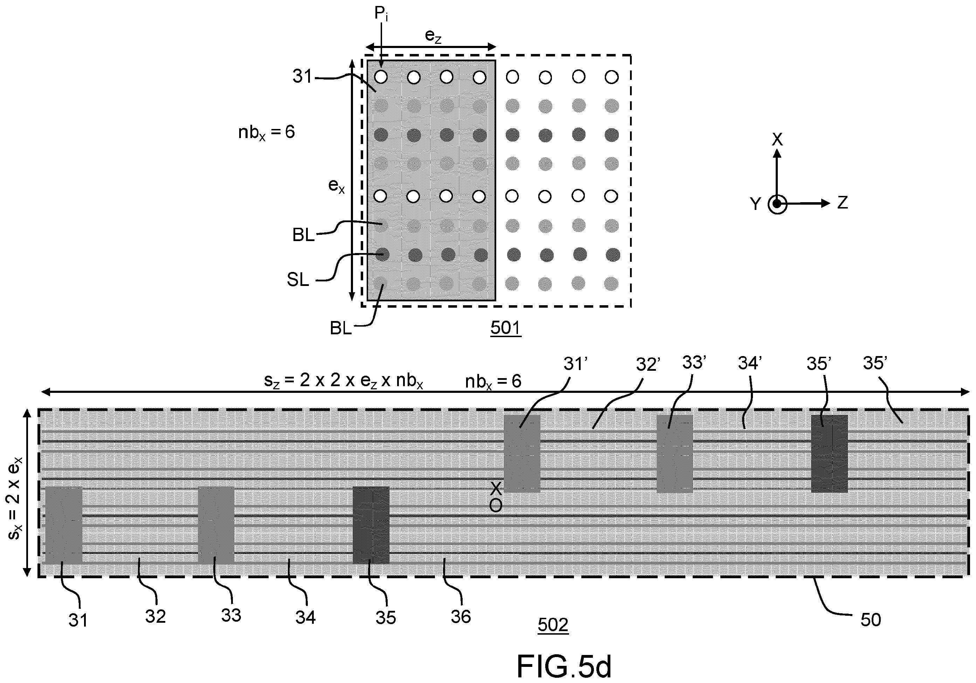

La figure 5d illustre une vue de dessus partielle de la structure mémoire tridimensionnelle illustrant le dimensionnement d'un motif unitaire 50 de la distribution des plots de connexion selon l'invention. Le schéma 501 illustre les dimensions d'un plot de connexion 31. Nous allons décrire l'exemple d'un plot de connexion rectangulaire mais le dimensionnement décrit reste valable pour toute forme possible des plots de connexion. Le plot de connexion présente une première dimension $e_z$ (largeur) selon une première direction Z et une seconde dimension $e_x$ selon une seconde direction X (longueur). Selon l'axe Z, chaque motif couvre partiellement un nombre prédéterminé $nb_z$ de plans mémoire successifs $P_1$ à $P_4$, (ici $nb_z$=4). Selon l'axe X, chaque motif couvre un nombre prédéterminé $nb_x$ (ici $nb_x$=6) de connecteurs (BL,SL) par plan mémoire couvert parmi $P_1$ à $P_4$.

Le dimensionnement optimal d'un motif unitaire 50 selon l'invention dépend des paramètres $e_z$ , $e_x$ , $nb_x$. Le schéma 501 illustre le dimensionnement optimal d'un motif unitaire 50 selon l'invention. La largeur $s_z$ du motif unitaire 50 selon la première direction Z est obtenue par l'équation suivante :

$$s_z = 2 * 2 * e_z * nb_x$$

La longueur $s_x$ du motif unitaire 50 selon la seconde direction X est obtenue par l'équation suivante :

$$s_x = 2 * e_x$$

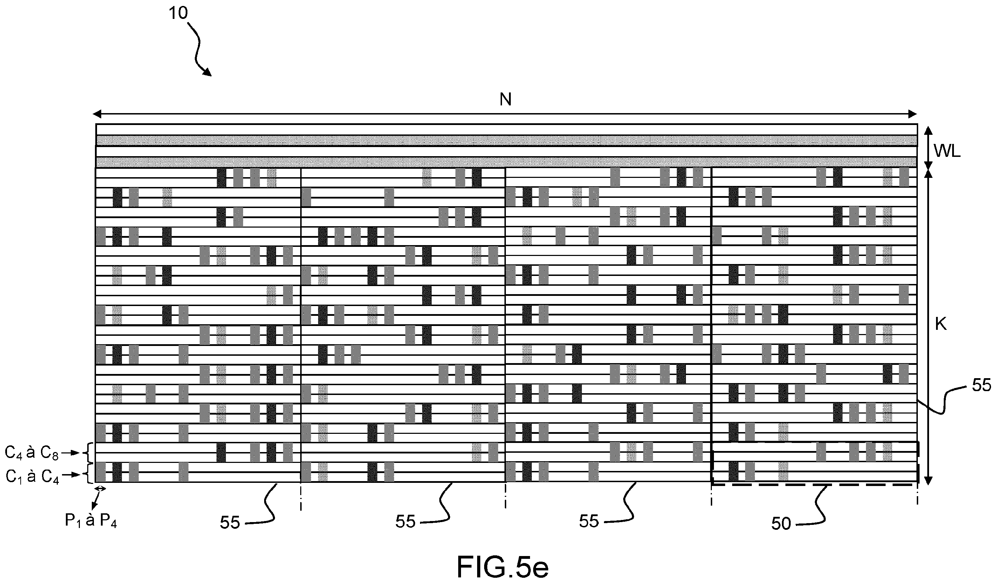

La figure 5e illustre une vue de dessus globale de la structure mémoire tridimensionnelle illustrant la distribution des plots de connexion selon le second mode de réalisation de l'invention.

Afin de connecter l'ensemble des cellules mémoire de la structure mémoire tridimensionnelle 10, le motif unitaire 50 est répété de manière à couvrir toute la surface supérieure de ladite structure tridimensionnelle 10. Les motifs unitaires couvrant les mêmes plans mémoires (adjacents selon l'axe x), couvrent une sous-matrice tridimensionnelle 55 de cellules mémoire. Les motifs unitaires 50 adjacents couvrant les mêmes colonnes $C_k$ (adjacents selon l'axe z) présentent des pistes métalliques 41 à 46 (et 41' à 46') distinctes. Pour chaque motif unitaire 50 la piste métallique 41 n'est pas connectée à la piste métallique 41 d'un motif unitaire 50 adjacent, la piste métallique 42 n'est pas connectée à la la piste métallique 42 d'un motif unitaire 50 adjacent et ainsi de suite. On obtient ainsi, une pluralité de sous-matrices tridimensionnelles 55 l'une à côté de l'autre. Chaque sous-matrice tridimensionnelle 55 est indépendante des autres en ce qui concerne les opérations de lecture, et d'écriture (en SET et en RESET). Cela permet d'améliorer la densité de la structure mémoire tout en augmentant le parallélisme des opérations de lecture et d'écriture (grâce à l'indépendance des sous-matrices tridimensionnelles 55).

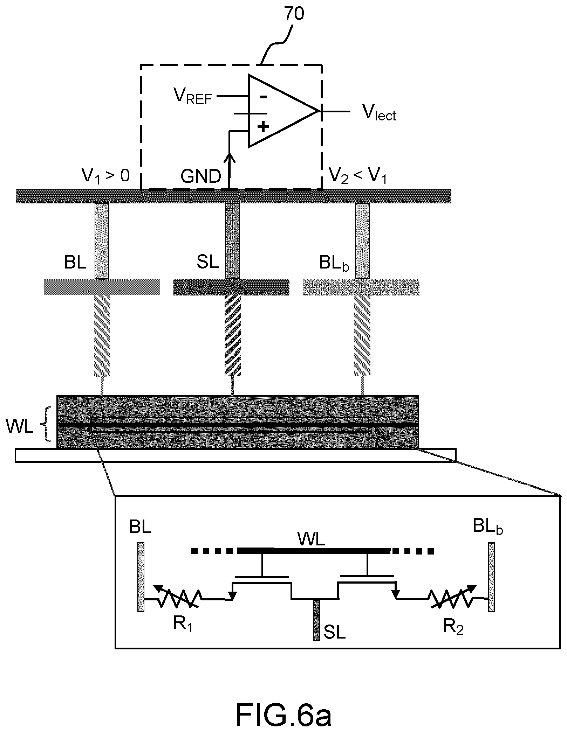

La figure 6a illustre un premier exemple d'un circuit de lecture 70 compatible avec l'invention. Le circuit de stockage de donnée comprend en outre pour chaque colonne $C_k$ de chaque plan mémoire $P_i$ , un circuit de lecture 70 réalisé sur le second substrat semiconducteur SUB2. Chaque circuit de lecture 70 comprend un comparateur 71 pour comparer un signal de lecture fourni par le premier nœud d'entrée/sortie SL de la cellule mémoire à lire à une tension de référence VREF (ou un courant de référence). Le signal de lecture est propagé à travers la structure d'interconnexion 30. Afin de lire la cellule mémoire CM1, le circuit de contrôle 20 (non représenté ici) est configuré pour appliquer une tension électrique positive $V_1$ sur second nœud d'entrée/sortie BL, et à maintenir le premier nœud d'entrée/sortie SL à la masse électrique. La cellule mémoire adjacente $CM_2$ partage le premier nœud d'entrée/sortie SL avec la cellule mémoire $CM_1$ à lire. Le second nœud d'entrée/sortie $BL_b$ de la cellule mémoire $CM_2$ est maintenu à la masse électrique. Cela induit un passage de courant $I_{SL}$ à travers le premier nœud d'entrée/sortie SL. Le comparateur permet d'évaluer l'état résistif de la cellule mémoire $CM_1$ et donc lire la donnée logique stockée dans ladite cellule mémoire.

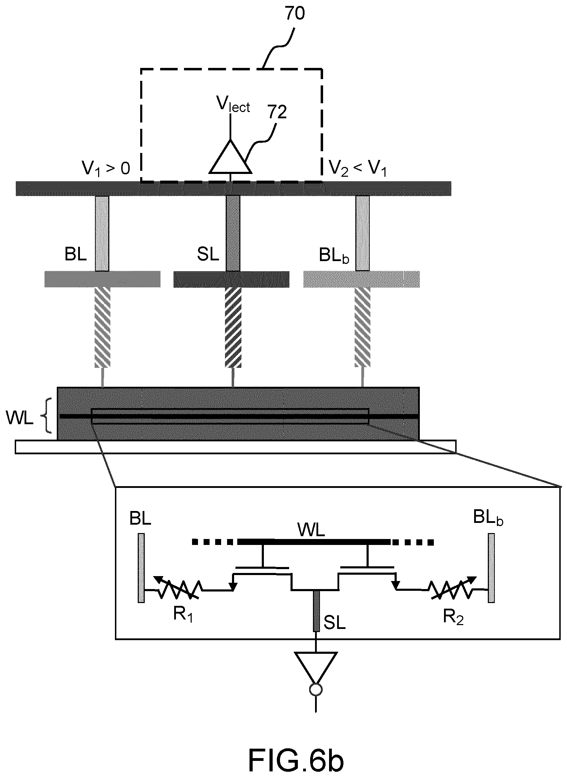

Alternativement, la figure 6b illustre un second exemple d'un circuit de lecture 70 compatible avec l'invention. Le circuit de stockage de donnée comprend en outre pour chaque colonne $C_k$ de chaque plan mémoire $P_i$ , un circuit de lecture 70 réalisé sur le second substrat semiconducteur SUB2. Chaque circuit de lecture 70 comprend un inverseur 72 connecté au premier nœud d'entrée/sortie SL de la cellule mémoire $CM_1$ à lire. Afin de lire la cellule mémoire $CM_1$, le circuit de contrôle 20 (non représenté ici) est configuré pour appliquer une tension électrique positive $V_1$ sur second nœud d'entrée/sortie BL. La cellule mémoire adjacente $CM_2$ partage le premier nœud d'entrée/sortie SL avec la cellule mémoire $CM_1$ à lire. Le circuit de contrôle 20 est configuré pour appliquer une tension électrique positive $V_2$ sur le second nœud d'entrée/sortie $BL_b$ de la cellule mémoire $CM_2$. La tension $V_2$ est inférieure à la tension $V_1$. La différence entre $V_1$ et $V_2$ est centrée sur la tension de seuil (ou de basculement) de l'inverseur. Si la cellule mémoire $CM_1$ stocke une donnée logique x=1 (état résistif bas), la tension $V_{lect}$ à la sortie de l'inverseur 71 est à l'état logique bas. Si la cellule mémoire $CM_1$ stocke une donnée logique x=0 (état résistif haut), la tension $V_{lect}$ à la sortie de l'inverseur 71 est à l'état logique haut.

Ce mode de réalisation permet de réaliser une lecture avec un circuit de lecture moins complexe, ce qui permet de simplifier l'implémentation et d'augmenter le parallélisme de lecture.

**Revendications**

1.  Circuit de stockage de données (1) de type NOR comprenant :

    - une structure mémoire tridimensionnelle (10), réalisée sur un premier substrat semiconducteur (SUB1), et comprenant une pluralité de plans mémoire $(P_i)$ de rang i allant de 1 à N, avec N un entier naturel supérieur à 1, chaque plan formant une matrice bidimensionnelle de cellules mémoire non volatiles, résistives et programmables, chaque cellule mémoire ayant un nœud de sélection (WL), un premier nœud d'entrée/sortie (SL) et un second nœud d'entrée/sortie (BL) ; ladite matrice comprenant M lignes $(L_j)$ de rang j allant de 1 à M et K colonnes $(C_k)$ de rang k allant de 1 à K, avec M et K deux entiers naturels non nuls;
    pour chaque plan mémoire $(P_i)$ :$_k$) sont interconnectés; et les seconds nœuds d'entrée/sorties (BL) des cellules mémoires appartenant à la même colonne $(C_k)$ sont interconnectés ; la structure mémoire tridimensionnelle (10) ayant une surface supérieure (Sur1) comprenant une pluralité de connecteurs $(BL_k, SL_k, BL_{kb})$ répartis sur ladite surface ; chaque connecteur $(BL_k, SL_k, BL_{kb})$ étant connecté à au moins l'un parmi les premiers ou les seconds nœuds d'entrée/sortie (SL, BL) d'une même colonne $(C_k)$ ;
    - un circuit de contrôle (20) configuré pour appliquer des tensions de commande (VBL, VSL, VWL) sur les nœuds de chaque cellule mémoire ; et réalisé sur un second substrat semiconducteur (SUB2); le circuit de contrôle (20) étant superposé à ladite surface supérieure (Sur1) ;
    - une structure d'interconnexion (30) comprenant :

        • une pluralité de plots de connexions (31, 32, 33) disposés entre le circuit de contrôle (20) et ladite surface supérieure (Sur1) ;

    chaque plot de connexion (31, 32, 33) connectant le circuit de contrôle (20) à un connecteur $(BL_k, SL_k, BL_{kb})$ dédié ; chaque plot de connexion (31, 32, 33) étant connecté à un groupe élémentaire de cellules mémoires appartenant à des plans mémoires distincts $(P_i)$, ladite pluralité de plots de connexion formant une répétition périodique d'un motif unitaire (50) dans un plan (XZ) parallèle à la surface supérieure (Sur1).

2.  Circuit de stockage de données (1) selon la revendication 1 dans lequel chaque plot de connexion (31, 32, 33) présente une première dimension $(e_z)$ selon une première direction (Z) et une seconde dimension $(e_x)$ selon une seconde direction (X) ;

    - la largeur $(s_z)$ selon la première direction (Z) du motif unitaire (50) selon la première direction (Z) étant égale à la première dimension $(e_z)$ multipliée par $4^* nb_x$, avec $nb_x$ le nombre de connecteurs $(BL_k, SL_k, BL_{kb})$ couverts par l'aire plot de connexion (31, 32, 33) appartenant à un même plan mémoire $(P_i)$ selon la seconde direction (X) ;
    - la longueur $(s_x)$ étant égale à deux fois la seconde dimension $(e_x)$ dudit plot de connexion (31, 32, 33) selon la seconde direction (X).

3.  Circuit de stockage de données (1) selon l'une quelconque des revendications 1 ou 2 dans lequel la structure d'interconnexion comprend en outre pour chaque groupe élémentaire (51) :

    • une première piste de connexion (40) pour interconnecter les premiers nœuds d'entrée/sortie (SL) des cellules mémoires (CM) appartenants à des colonnes $(C_k)$ de même rang k d'une pluralité de plans mémoire distincts ;
    • une seconde piste de connexion (41) pour interconnecter les seconds nœuds d'entrée/sortie (BL) des cellules mémoires (CM) appartenants à des colonnes $(C_k)$ de même rang k d'une pluralité de plans mémoire distincts.

4.  Circuit de stockage de données (1) selon l'une quelconque des revendications précédentes comprenant en outre une couche de diélectrique (60) encapsulant la structure mémoire tridimensionnelle (10) et supportant la pluralité de plots de connexions (31, 32, 33) ; et dans lequel la structure d'interconnexion (30) comprend en outre un ensemble de vias (38) traversant la couche de diélectrique (60), chaque via (38) parmi l'ensemble de vias étant destiné à connecter un plot de connexions (31, 32, 33) à un connecteur ($BL_k$, $SL_k$, $BL_{kb}$) associé.

5. Circuit de stockage de données (1) selon l'une quelconque des revendications 1 à 4 comprenant en outre au moins un circuit de lecture (70) réalisé sur le second substrat semiconducteur (SUB2).

6. Circuit de stockage de données (1) selon la revendication 5 dans lequel chaque circuit de lecture (70) comprend un inverseur (72) apte à réaliser une lecture différentielle de deux cellules mémoires appartenant à deux colonnes adjacentes et ayant un premier nœud d'entrée/sortie (SL) commun et ayant deux seconds nœuds d'entrée/sortie ($BL_1$, $BL_{1b}$) destinés à recevoir des signaux de commande ($VBL_1$, $VBL_{1b}$) complémentaires.

7. Circuit de stockage de données (1) selon l'une quelconque des revendications précédentes dans lequel chaque cellule mémoire (CM) comprend :

- une structure de stockage résistive programmable ayant :

• une électrode supérieure (EL1) connectée au second nœud d'entrée/sortie (BL) de ladite cellule mémoire (CM) ;
• et une électrode inférieure (EL2) ;

- un transistor de sélection (T1) ayant une grille connectée au nœud de sélection (WL) de ladite cellule mémoire et reliant l'électrode inférieure (EL2) au premier nœud d'entrée/sortie (SL) de ladite cellule mémoire (CM).

8. Circuit de stockage de données (1) selon la revendication 7 dans lequel chaque colonne ($C_k$) de cellules mémoire (CM) comprend :

- Un empilement d'une pluralité de transistors de sélection (T1) selon une première direction (Δ) ;

chaque transistor de sélection étant de type grille enrobante et comprenant un canal de conduction (CC), perpendiculaire à la première direction (Δ) en un matériau semiconducteur et ayant deux extrémités ;
la première extrémité du canal correspondant à la source du transistor de sélection et la seconde correspondant au drain du transistor ;

- un premier pilier métallique ($BL_1$) selon la première direction (Δ) connectant les sources des différents transistors de sélection ;
- une seconde couche en diélectrique (C'2) parallèle à la première direction (Δ) et couvrant latéralement les drains des transistors de sélection ;
- au moins une couche métallique (C'3) parallèle à la première direction et déposée sur la couche en diélectrique ;
- un second pilier métallique ($BL_{1b}$) selon la première direction (Δ) ayant un contact latéral avec l'au moins une couche métallique ;

pour chaque transistor de sélection, l'ensemble formé par la source, la couche en diélectrique (C'2) et la couche métallique (C'3) constitue une structure de stockage élémentaire résistive (S1).

9. Circuit de stockage de données (1) selon l'une quelconque des revendications 1 à 8 dans lequel :

- l'aire d'un plot de connexion est égale à l'aire d'une zone de la surface supérieure (Sur1) comprenant un seul connecteur ($BL_1$, $SL_1$, $BL_{1b}$) ;
- le motif unitaire (50) comprend trois plots de connexions (31, 32, 33) ;
- le motif unitaire (50) couvre un groupe élémentaire (51) de cellules mémoires appartenant à six plans mémoires distincts ($P_i$) successifs.

10. Circuit de stockage de données (1) selon l'une quelconque des revendications 1 à 8 dans lequel :

- l'aire d'un plot de connexion est égale à l'aire d'une zone de la surface supérieure (Sur1) comprenant au moins six connecteurs ($BL_1$, $SL_1$, $BL_{1b}$, $BL_2$, $SL_2$, $BL_{2b}$) ;
- le motif unitaire (50) comprend au moins six plots de connexions (31, 32, 33, 34, 35, 36) ;
- le motif unitaire (50) couvre un groupe élémentaire (51) de cellules mémoires appartenant à au moins 96 plans mémoires distincts ($P_i$) successifs.

11. Circuit de stockage de données (1) selon l'une quelconque des revendications précédentes dans lequel le motif unitaire (50) comprend un premier sous-groupe de plots de connexion et un deuxième sous-groupe de plots de connexion, les sous-groupes étant symétriques l'un par rapport à l'autre selon un point central (O) du motif unitaire (50).

12. Circuit de stockage de données (1) selon l'une quelconque des revendications précédentes dans lequel le motif unitaire (50) recouvre deux groupes d'un nombre égal de colonne(s), chaque groupe de colonne(s) étant connecté à un même nombre de plots de connexion.

**Patentansprüche**

1. Datenspeicherschaltung (1) vom NOR-Typ, die Folgendes umfasst:

   - eine dreidimensionale Speicherstruktur (10), die auf einem ersten Halbleitersubstrat (SUB1) entwickelt ist und eine Vielzahl von Speicherebenen ($P_i$) mit Rang i von 1 bis N umfasst, wobei N eine natürliche Zahl größer als 1 ist, wobei jede Ebene eine zweidimensionale Matrix aus nichtflüchtigen, resistiven und programmierbaren Speicherzellen bildet, wobei jede Speicherzelle einen Auswahlknoten (WL), einen ersten Ein-/Ausgangsknoten (SL) und einen zweiten Ein-/Ausgangsknoten (BL) hat; wobei die Matrix M Zeilen ($L_j$) mit Rang j von 1 bis M und K Spalten ($C_k$) mit Rang k von 1 bis K umfasst, wobei M und K zwei natürliche Zahlen ungleich Null sind;
   für jede Speicherebene <u>(Pi)</u>: die ersten Ein-/Ausgangsknoten (SL) der zur selben Spalte (Ck) gehörenden Speicherzellen sind miteinander verbunden; und die zweiten Ein-/Ausgangsknoten (BL) der zur selben Spalte ($C_k$) gehörenden Speicherzellen sind miteinander verbunden; die dreidimensionale Speicherstruktur (10) hat eine obere Fläche (Sur1), die eine Vielzahl von auf dieser Fläche verteilten Verbindern ($BL_k$, $SL_k$, $BL_{kb}$) umfasst; wobei jeder Verbinder ($BL_k$, $SL_k$, $BL_{kb}$) mit mindestens einem der ersten oder zweiten Ein-/Ausgangsknoten (SL, BL) einer selben Spalte ($C_k$) verbunden ist:
   - eine Steuerschaltung (20), die zum Anlegen von Steuerspannungen (VBL, VSL, VWL) an die Knoten jeder Speicherzelle konfiguriert ist, und auf einem zweiten Halbleitersubstrat (SUB2) entwickelt ist, wobei die Steuerschaltung (20) der oberen Fläche (Sur1) überlagert ist;
   - eine Verbindungsstruktur (30), die Folgendes umfasst:

      • eine Vielzahl von Verbindungspads (31, 32, 33), die zwischen der Steuerschaltung (20) und der oberen Fläche (Sur1) angeordnet sind;

   wobei jedes Verbindungspad (31, 32, 33) die Steuerschaltung (20) mit einem dedizierten Verbinder ($BL_k$, $SL_k$, $BL_{kb}$) verbindet; wobei jedes Verbindungspad (31, 32, 33) mit einer elementaren Gruppe von Speicherzellen verbunden ist, die zu separaten Speicherebenen ($P_i$) gehören, wobei die Vielzahl von Verbindungspads eine periodische Wiederholung eines Einheitsmusters (50) in einer Ebene (XZ) parallel zur oberen Fläche (Sur1) bildet.

2. Datenspeicherschaltung (1) nach Anspruch 1, wobei jedes Verbindungspad (31, 32, 33) eine erste Abmessung ($e_z$) in einer ersten Richtung (Z) und eine zweite Abmessung ($e_x$) in einer zweiten Richtung (X) aufweist;

   - die Breite ($s_z$) in der ersten Richtung (Z) des Einheitsmusters (50) in der ersten Richtung (Z) gleich der ersten Abmessung ($e_z$) multipliziert mit 4*$nb_x$ ist, wobei $nb_x$ die Anzahl der Verbinder ($BL_k$, $SL_k$, $BL_{kb}$) ist, die von der Fläche des Verbindungspads (31, 32, 33) abgedeckt werden, die zu derselben Speicherebene ($P_i$) in der zweiten Richtung (X) gehören;
   - wobei die Länge ($s_x$) gleich dem Doppelten der zweiten Abmessung ($e_x$) des Verbindungspads (31, 32, 33) in der zweiten Richtung (X) ist.

3. Datenspeicherschaltung (1) nach einem der Ansprüche 1 oder 2, wobei die Verbindungsstruktur für jede Elementargruppe (51) ferner Folgendes umfasst:

   • eine erste Verbindungsbahn (40) zum Verbinden der ersten Ein-/Ausgangsknoten (SL) der Speicherzellen (CM), die zu Spalten ($C_k$) mit gleichem Rang k einer Vielzahl von separaten Speicherebenen gehören;
   • eine zweite Verbindungsbahn (41) zum Verbinden der zweiten Ein-/Ausgangsknoten (BL) der Speicherzellen (CM), die zu Spalten ($C_k$) mit gleichem Rang k einer Vielzahl von separaten Speicherebenen gehören.

4. Datenspeicherschaltung (1) nach einem der vorhergehenden Ansprüche, die ferner eine dielektrische Schicht (60) umfasst, die die dreidimensionale Speicherstruktur (10) einkapselt und die Vielzahl von Verbindungspads (31, 32, 33) trägt; und wobei die Verbindungsstruktur (30) ferner einen Satz von Durchkontaktierungen (38) umfasst, die die dielektrische Schicht (60) durchqueren, wobei jede Durchkontaktierung (38) des Satzes von Durchkontaktierungen zum Verbinden eines Verbindungspads (31, 32, 33) mit einem assoziierten Verbinder ($BL_k$, $SL_k$, $BL_{kb}$) bestimmt ist.

5. Datenspeicherschaltung (1) nach einem der Ansprüche 1 bis 4, die ferner mindestens eine auf dem zweiten Halbleitersubstrat (SUB2) entwickelte Leseschaltung (70) umfasst.

**6.** Datenspeicherschaltung (1) nach Anspruch 5, wobei jede Leseschaltung (70) einen Inverter (72) umfasst, der zum Durchführen von Differenzlesen von zwei Speicherzellen geeignet ist, die zu zwei benachbarten Spalten gehören und einen gemeinsamen ersten Ein-/Ausgangsknoten (SL) und zwei zweite Ein-/Ausgangsknoten ($BL_1$, $BL_{1b}$), die zum Empfangen komplementärer Steuersignale ($VBL_1$, $VBL_{1b}$) bestimmt sind, hat.

**7.** Datenspeicherschaltung (1) nach einem der vorhergehenden Ansprüche, wobei jede Speicherzelle (CM) Folgendes umfasst:

- eine programmierbare resistive Speicherstruktur mit:

• einer oberen Elektrode (EL1), die mit dem zweiten Ein-/Ausgangsknoten (BL) der Speicherzelle (CM) verbunden ist;
• und einer unteren Elektrode (EL2);

- einen Auswahltransistor (T1), der ein mit dem Auswahlknoten (WL) der Speicherzelle verbundenes Gate aufweist, und der die untere Elektrode (EL2) mit dem ersten Ein-/Ausgangsknoten (SL) der Speicherzelle (CM) verbindet.

**8.** Datenspeicherschaltung (1) nach Anspruch 7, wobei jede Spalte ($C_k$) von Speicherzellen (CM) Folgendes umfasst:

- einen Stapel aus einer Vielzahl von Auswahltransistoren (T1) in einer ersten Richtung ($\Delta$);

wobei jeder Auswahltransistor vom Gate-All-Around-Typ ist und einen Leitungskanal (CC) aus einem Halbleitermaterial lotrecht zur ersten Richtung ($\Delta$) mit zwei Enden umfasst;
wobei das erste Ende des Kanals der Source des Auswahltransistors und das zweite dem Drain des Transistors entspricht;

- eine erste Metallsäule ($BL_1$) in der ersten Richtung ($\Delta$), die die Sources der verschiedenen Auswahltransistoren verbindet;
- eine zweite dielektrische Schicht (C'2) parallel zur ersten Richtung ($\Delta$), die die Drains der Auswahltransistoren seitlich abdeckt;
- mindestens eine Metallschicht (C'3) parallel zur ersten Richtung, die auf die dielektrische Schicht aufgebracht ist;
- eine zweite Metallsäule ($BL_{1b}$) in der ersten Richtung ($\Delta$), die einen seitlichen Kontakt mit der mindestens einen Metallschicht hat;

für jeden Auswahltransistor bildet die durch die Source, die dielektrische Schicht (C'2) und die Metallschicht (C'3) gebildete Anordnung eine resistive Elementarspeicherstruktur (S1).

**9.** Datenspeicherschaltung (1) nach einem der Ansprüche 1 bis 8, wobei:

- der Bereich eines Verbindungspads gleich dem Bereich einer Zone der oberen Fläche (Sur1) ist, der einen einzelnen Verbinder ($BL_1$, $SL_1$, $BL_{1b}$) umfasst:
- das Einheitsmuster (50) drei Verbindungspads (31, 32, 33) umfasst;
- das Einheitsmuster (50) eine Elementargruppe (51) von Speicherzellen abdeckt, die zu sechs aufeinanderfolgenden, separaten Speicherebenen ($P_i$) gehören.

**10.** Datenspeicherschaltung (1) nach einem der Ansprüche 1 bis 8, wobei:

- der Bereich eines Verbindungspads gleich dem Bereich einer Zone der oberen Fläche (Sur1) ist, der mindestens sechs Verbinder ($BL_1$, $SL_1$, $BL_{1b}$, $BL_2$, $SL_2$, $BL_{2b}$) umfasst;
- das Einheitsmuster (50) mindestens sechs Verbindungspads (31, 32, 33, 34, 35, 36) umfasst;
- das Einheitsmuster (50) eine Elementargruppe (51) von Speicherzellen abdeckt, die zu mindestens 96 aufeinanderfolgenden, getrennten Speicherebenen ($P_i$) gehören.

**11.** Datenspeicherschaltung (1) nach einem der vorhergehenden Ansprüche, wobei das Einheitsmuster (50) eine erste Untergruppe von Verbindungspads und eine zweite Untergruppe von Verbindungspads umfasst, wobei die Untergruppen in Bezug auf einen Mittelpunkt (O) des Einheitsmusters (50) symmetrisch zueinander sind.

**12.** Datenspeicherschaltung (1) nach einem der vorhergehenden Ansprüche, wobei das Einheitsmuster (50) zwei Gruppen mit einer gleichen Anzahl von einer oder mehreren Spalten abdeckt, wobei jede Gruppe von einer oder mehreren Spalten mit einer gleichen Anzahl von Verbindungspads verbunden ist.

**Claims**

**1.** A data storage circuit (1) of NOR type comprising:

- a three-dimensional memory structure (10), produced on a first semiconductor substrate (SUB1), and comprising a plurality of memory planes ($P_i$) of rank i ranging from 1 to N, with N a natural number greater than 1, each plane forming a two-dimensional array of non-volatile, resistive and programmable memory cells, each memory cell having a selection node (WL), a first input/output node (SL) and a second input/output node (BL); said array comprising M rows ($L_j$) of rank j ranging from 1 to M and K columns ($C_k$) of rank k ranging from 1 to K, with M and K two non-zero natural numbers;

for each memory plane (Pi): the first input/output nodes (SL) of the memory cells belonging to one and the same column ($C_k$) are interconnected; and the second input/output nodes (BL) of the memory cells belonging to one and the same column ($C_k$) are interconnected; the three-dimensional memory structure (10) having an upper surface (Sur1) comprising a plurality of connectors ($BL_k$, $SL_k$, $BL_{kb}$) distributed over said surface; each connector ($BL_k$, $SL_k$, $BL_{kb}$) being connected to at least one among the first or second input/output nodes (SL, BL) of a given column ($C_k$);

- a control circuit (20) configured to apply control voltages (VBL, VSL, VWL) to the nodes of each memory cell; and produced on a second semiconductor substrate (SUB2); the control circuit (20) is superposed on said upper surface (Sur1);

- an interconnection structure (30) comprising:

• a plurality of bonding pads (31, 32, 33) placed between the control circuit (20) and said upper surface (Sur1);

each bonding pad (31, 32, 33) connects the control circuit (20) to a dedicated connector ($BL_k$, $SL_k$, $BL_{kb}$); each bonding pad (31, 32, 33) being connected to an elementary group of memory cells belonging to separate memory planes ($P_i$), said plurality of bonding pads forming a periodic repetition of a unit pattern (50) in a plane (XZ) parallel to the upper surface (Sur1).

2. The data storage circuit (1) according to claim 1, wherein each bonding pad (31, 32, 33) has a first dimension ($e_z$) in a first direction (Z) and a second dimension ($e_x$) in a second direction (X);

- the width ($s_z$) in the first direction (Z) of the unit pattern (50) in the first direction (Z) being equal to the first dimension ($e_z$) multiplied by $4*nb_x$, with $nb_x$ the number of connectors ($BL_k$, $SL_k$, $BL_{kb}$) covered by the area of the bonding pad (31, 32, 33) belonging to one and the same memory plane ($P_i$) in the second direction (X);
- the length ($s_x$) is equal to twice the second dimension ($e_x$) of said bonding pad (31, 32, 33) in the second direction (X).

3. The data storage circuit (1) according to any one of claim 1 or 2, wherein the interconnection structure further comprises for each elementary group (51):

• a first connection track (40) for interconnecting the first input/output nodes (SL) of the memory cells (CM) belonging to columns ($C_k$) of one and the same rank k of a plurality of separate memory planes;
• a second connection track (41) for interconnecting the second input/output nodes (SL) of the memory cells (CM) belonging to columns ($C_k$) of one and the same rank k of a plurality of separate memory planes.

4. The data storage circuit (1) according to any one of the preceding claims, further comprising a dielectric layer (60) encapsulating the three-dimensional memory structure (10) and bearing the plurality of bonding pads (31, 32, 33); and wherein the interconnection structure (30) further comprises a set of through-vias (38) passing through the dielectric layer (60), each via (38) among the set of vias being intended to connect one bonding pad (31, 32, 33) to one associated connector ($BL_k$, $SL_k$, $BL_{kb}$).

5. The data storage circuit (1) according to any one of claims 1 to 4, further comprising at least one read circuit (70) produced on the second semiconductor substrate (SUB2).

6. The data storage circuit (1) according to claim 5, wherein each read circuit (70) comprises an inverter (72) able to carry out a differential read of two memory cells belonging to two adjacent columns and having a common first input/output node (SL) and having two second input/output nodes ($BL_1$, $BL_{1b}$) intended to receive complementary control signals ($VBL_1$, $VBL_{1b}$).

7. The data storage circuit (1) according to any one of the preceding claims, wherein each memory cell (CM) comprises:

- a programmable resistive storage structure having:

• an upper electrode (EL1) connected to the second input/output node (BL) of said memory cell (CM);
• and a lower electrode (EL2);

- a selection transistor (T1) having a gate connected to the selection node (WL) of said memory cell and connecting the lower electrode (EL2) to the first input/output node (SL) of said memory cell (CM).

**8.** The data storage circuit (1) according to claim 7, wherein each column ($C_k$) of memory cells (CM) comprises:

- a stack of a plurality of selection transistors (T1) in a first direction ($\Delta$);

each selection transistor being of gate-all-around type and comprising, perpendicular to the first direction ($\Delta$), a conduction channel (CC) made of a semiconductor material and having two ends;
the first end of the channel corresponding to the source of the selection transistor and the second corresponding to the drain of the transistor;

- in the first direction ($\Delta$), a first metal pillar ($BL_1$) connecting the sources of the various selection transistors;
- a second dielectric layer (C'2) parallel to the first direction ($\Delta$) and laterally covering the drains of the selection transistors;
- at least one metal layer (C'3) parallel to the first direction and deposited on the dielectric layer;
- in the first direction ($\Delta$), a second metal pillar ($BL_{1b}$) making lateral contact with the at least one metal layer;

for each selection transistor, the assembly formed by the source, the dielectric layer (C'2) and the metal layer (C'3) forms an elementary resistive storage structure (S1).

**9.** The data storage circuit (1) according to any one of claims 1 to 8, wherein:

- the surface area of a bonding pad is equal to the surface area of a region of the upper surface (Sur1) comprising a single connector ($BL_1$, $SL_1$, $BL_{1b}$);
- the unit pattern (50) comprises three bonding pads (31, 32, 33);
- the unit pattern (50) covers an elementary group (51) of memory cells belonging to six successive separate memory planes ($P_i$).

**10.** The data storage circuit (1) according to any one of claims 1 to 8, wherein:

- the surface area of a bonding pad is equal to the surface area of a region of the upper surface (Sur1) comprising at least six connectors ($BL_1$, $SL_1$, $BL_{1b}$, $BL_2$, $SL_2$, $BL_{2b}$);
- the unit pattern (50) comprises at least six bonding pads (31, 32, 33, 34, 35, 36);
- the unit pattern (50) covers an elementary group (51) of memory cells belonging to at least 96 successive separate memory planes ($P_i$).

**11.** The data storage circuit (1) according to any one of the preceding claims, wherein the unit pattern (50) comprises a first sub-group of bonding pads and a second sub-group of bonding pads, the sub-groups being symmetrical with respect to each other about a central point (O) of the unit pattern (50).

**12.** The data storage circuit (1) according to any one of the preceding claims, wherein the unit pattern (50) covers two groups of an equal number of one or more columns, each group of one or more columns being connected to one and the same number of bonding pads.

FIG.1a

FIG.1b

FIG.2

EP 4 369 884 B1

FIG.3a

FIG.3b

FIG.3c

FIG.3d

FIG.4a

EP 4 369 884 B1

FIG.4b

EP 4 369 884 B1

FIG.4c

EP 4 369 884 B1

FIG.5a

EP 4 369 884 B1

FIG.5b

EP 4 369 884 B1

FIG.5c

EP 4 369 884 B1

$P_i$

$e_z$

31

$nb_x = 6$

$e_x$

BL

SL

BL

501

X

Y Z

$s_z = 2 \times 2 \times e_z \times nb_x$    $nb_x = 6$

31'  32'  33'  34'  35'  35'

$s_x = 2 \times e_x$

X
O

31  32  33  34  35  36

502

50

FIG.5d

FIG.5e

FIG.6a

FIG.6b

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20220157845 A1